**Europäisches Patentamt**

**European Patent Office**

**Office européen des brevets**

(11) Publication number: **0 279 596 B1**

# EUROPEAN PATENT SPECIFICATION

(45) Date of publication of patent specification: **29.09.93**　(51) Int. Cl.⁵: **H01F 27/24**, H01F 40/02

(21) Application number: **88301167.8**

(22) Date of filing: **12.02.88**

(54) **Electromagnetic contactor with lightweight wide range current transducer with sintered powdered metal core.**

(30) Priority: **19.02.87 US 16420**
**21.10.87 US 111007**

(43) Date of publication of application:
**24.08.88 Bulletin 88/34**

(45) Publication of the grant of the patent:
**29.09.93 Bulletin 93/39**

(84) Designated Contracting States:
**DE FR GB IT SE**

(56) References cited:
DE-A- 1 763 092　　GB-A- 1 275 787
JP-A- 618 910　　US-A- 3 197 721
US-A- 3 339 161　　US-A- 3 449 703
US-A- 4 007 414　　US-A- 4 368 424
US-A- 4 454 557

Patent Abstracts of Japan, Vol. 10, No. 150
(E-408)(2207), 31.05.86

(73) Proprietor: **WESTINGHOUSE ELECTRIC COR-PORATION**
**Westinghouse Building Gateway Center**
**Pittsburgh Pennsylvania 15222(US)**

(72) Inventor: **Engel, Joseph Charles**
**107 Overlook Circle**
**Monroeville PA 15146(US)**

(74) Representative: **Charlton, Peter John et al**
**Elkington and Fife Prospect House 8 Pembroke Road**
**Sevenoaks, Kent TN13 1XR (GB)**

Rank Xerox (UK) Business Services
(3. 10/3.6/3.3. 1)

**Description**

The invention relates to a transducer and generally to electromagnetic contactors, more specifically to apparatus for sensing contactor current.

Electromagnetic contactors are known from the specification of U.S. Patent 3,339,161. Electromagnetic contactors are switch devices which are especially useful in motor starting, lighting, switching and similar applications. A motor starting contactor with an overload relay system is called a motor controller. Contactors and motor controllers sense the electrical current flowing through the closed contacts and use information related to that current for useful purposes. Often the current is sensed with classical well known current transformers where an output current which is generally proportional to the input current is provided. The traditional current transformer approach has a number of disadvantages. One disadvantages lies in the fact that traditional current transformers are only usable over a relatively small range of input current. To measure input currents outside of this range the current transformer must be replaced by larger or smaller one. Another disadvantage lies in the fact that current transformers are typically relatively large and relatively heavy. This is very disadvantageous in situations where it is desirous to minimize the size of motor controller or contactor parts. It would be desirous therefore to provide a motor contactor or controller which utilized a current transformer or transducer which was relatively small and yet useful over a wide range of input current. Until now it has been difficult to find current transformer arrangements which meet both of the above-named criteria. The specification of U.S. Patent 4,454,557 teaches a transformer device which is useful over a relatively wide range but which accomplishes the latter by deliberately providing a non-linear output. Furthermore, the transformer is utilized in various stages of saturation which is usually associated with a relatively heavy transformer with higher losses. Other current transducer arrangements in the specifications of U.S. Patent Nos. 3,197,721 and 4,007,414.

However, a problem may be associated with the transducer output being influenced by the affect of stray magnetic flux. This problem has been solved in the past by utilizing a current transformer in which the secondary winding thereof is disposed about a non-magnetic insulating material in an even number of successive layers. The inner layer extends from a first point on the core along substantially the entire core length to a second point closely adjacent the first point then the outer layer extends from the second point back to the first point. The winding turns in these layers are wound about the core in the same direction and both layers have a substantially equal number of turns distributed substantially uniformly along the length of the core. This has a tendency to reduce the affect of stray magnetic fields however it requires the use of a relatively tedious winding process which is time consuming and relatively expensive. Such a current transformer is in the specification of U.S. Patent 3,449,703. Iron powder toroidal cores which have relatively low permeability are disclosed in a publication entitled "Pyroferric" published by Pyroferric International Inc. of Toledo, IL. It would be advantageous if a current transducer could be found which could be utilized with a microprocessor controlled motor contactor or controller which had the advantages associated with the previously described copending application and which was not impaired by stray magnetic flux but was nevertheless relatively simple and inexpensive to construct. In the specification of U.S. Patent 4,368,424 the discrete gapped core and air core current transducers are described.

Accordingly, there is provided a contactor of the kind which opens and closes an electrical circuit, comprising:

a current-to-voltage transducer and voltage sensitive means disposed to receive an electrical voltage V and to open said electrical circuit when required in response thereto, said current-to-voltage transducer comprising:

a homogeneous magnetic core;

a primary winding (L1) disposed to electromagnetically interact with said homogeneous magnetic core for providing magnetic flux in said homogeneous magnetic core in general proportion to the amount of electrical current I flowing in said primary winding means (L1) for values of said electrical current I within a given range of current I;

said homogeneous magnetic core comprising generally homogeneously dispersed magnetic regions and non-magnetic regions therein, said homogeneous magnetic core having a Rayleigh Constant $\lambda$ of such magnitude that a value $\lambda H$ is significantly less than the initial permeability $\mu_0$ of the homogeneous magnetic core, thus causing the relationship:

$$\frac{d(\mu_0 + \lambda H)I}{dt} \simeq \mu_0 \frac{dI}{dt}$$

for said entire range of current I, where H equals the electromagnetic field strength attributable to said magnetic flux;

a secondary winding disposed on said homogeneous magnetic core for providing said electrical voltage V at the output terminals thereof which is generally approximately proportional to the first derivative of said current I with respect to time for said entire range of current I.

Conveniently, the invention includes electrical apparatus such as motor control apparatus of the kind which performs a motor control operation as a function of motor current. The motor control includes a current-to-voltage transducer which in turn includes a homogeneous magnetic core material. There is a primary winding means disposed in relationship with the magnetic core material to electrically interact therewith for providing magnetic flux in the homogeneous core material in general proportion to the amount of electrical current flowing in the primary winding. The core material comprises powdered metal with homogeneous microscopic air gaps which provide the magnetic reluctance which prevents magnetic saturation of the homogeneous magnetic core for values of electrical current I less than or equal to a predetermined amount. A relatively simple secondary winding is disposed upon the homogeneous magnetic core with little regard for spacing or distribution of the windings for providing an electrical voltage at the output terminals thereof which is generally proportional to the first derivative of the previously described input current. Furthermore, voltage sensing means is provided to receive the electrical voltage signal to provide a control operation for the controller in response to the voltage.

The invention will now be described, by way of example, with reference to the accompanying drawings in which:

Figure 1 shows an isometric view of an electro-magnetic contactor;

Figure 2 shows a cutaway elevation of the contactor of Fig. 1 at section II-II thereof;

Figure 3 shows a cutaway elevation of a contactor similar to that shown in Figures 1 and 2 for another embodiment of the invention;

Figure 4 shows a sectional view of the contactor of Figure 3 along the section lines XXXII-XXXII;

Figure 5 shows plots of VLINE, VRUN(T), and VRUN(F) at the input of the microprocessor;

Figure 6 shows a plan view of a printed circuit board similar to that shown in Figures 8 and 9 for utilization in another embodiment of the invention;

Figures 7A through 7D show a schematic circuit diagram partially in block diagram form for an electrical control system for the contactor of Figs. 1 and 2;

Figure 8 shows a plan view of a printed circuit board which includes the circuit elements of Fig. 7 as well as the contactor coil, current transducers and voltage transformers of Fig. 2;

Figure 9 shows an elevation of the circuit board of Fig. 8;

Figure 10 shows the circuit board of Figs. 8 and 9 in isometric view in a disposition for mounting in the contactor of Fig. 2;

Figure 11 shows a circuit diagram and wiring schematic partially in block diagram form for the contactor of Figs. 2 and 7 as utilized in conjunction with a motor controlled thereby;

Figure 12 shows a schematic arrangement of a current-to-voltage transducer for utilization in an embodiment of the present invention;

Figure 13 shows a schematic arrangement of the transformer of Fig. 12 with an integrator circuit;

Figure 14 shows a plot of air gap length versus the voltage-to-current ratio for the transducer arrangements of Figs. 12 and 13;

Figure 15 shows an embodiment of a current-to-voltage transducer utilizing a magnetic shim;

Figure 16 shows an embodiment of a current-to-voltage transducer using an adjustable protrusion member;

Figure 17 shows an embodiment of a current-to-voltage transducer utilizing a movable core portion;

Figure 18 shows an embodiment of a current-to-voltage transducer according to the invention utilizing a powdered metal core;

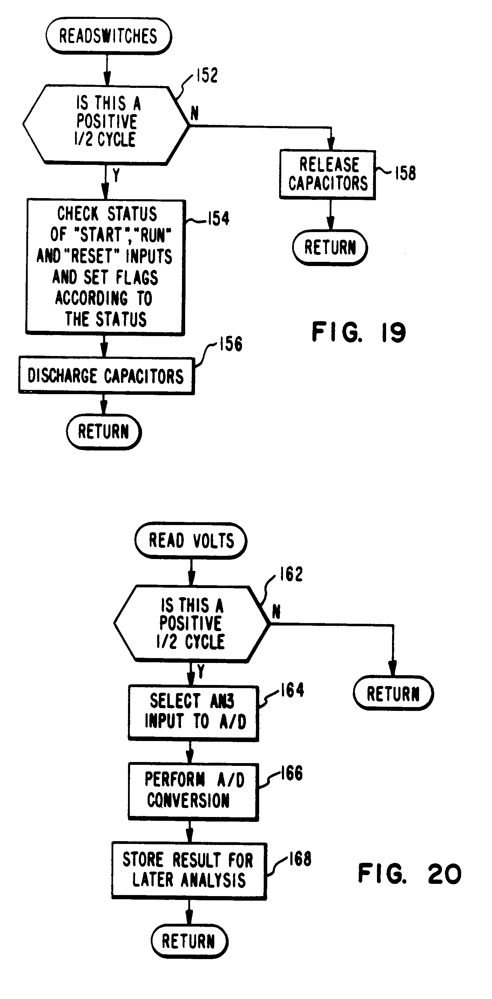

Figure 19 shows an algorithm, READSWITCHES, in block diagram form for utilization by a microprocessor for reading switches and discharging capacitors for the input circuitry of the coil control board of Figure 7;

Figure 20 shows an algorithm, READVOLTS, in block diagram form for reading line voltage for the coil control board of Figure 7;

Figure 21 shows an algorithm, CHOLD, in block diagram form for reading the coil current for the coil control circuit of Figure 7;

Figure 22 shows an algorithm, RANGE, in block diagram form for reading line current as determined by the overload relay board of Figure 7;

Figure 23 shows a schematic representation of an A-to-D converter and storage locations associated with determining line current as found in the microprocessor of the coil control board of the present invention; Figure 24 shows an algorithm, FIRE TRIAC, in block diagram form for utilization by a microprocessor for firing the coil controlling triac for the coil control board of Figure 7:

Figure 25A shows a plot of the derivatives of the line current shown in Figure 25A;

Figure 25B shows a plot of a one-half per unit, a one per unit and a two per unit sinusoidal representation of a line current for the apparatus controlled by the present invention;

Figure 25C shows a plot of resultant analog-to-digital converter input voltage versus half-cycle sampling intervals (time) for three examples of line current magnitude of Figure 25A;

Figure 26 shows a representation of the binary numbers stored in storage locations in the microprocessor of Fig. 23 for Example 1 of an analog-to-digital conversion for six sampling times in the RANGE sampling routine of Figure 22 for the one-half per unit line cycle;

Figure 27 shows a representation of the binary numbers stored in storage locations in the microprocessor of Fig. 23 for Example 2 of an analog-to-digital conversion for six sampling times in the RANGE sampling routine of Figure 22 for the one per unit line cycle;

Figure 28 shows a representation of the binary numbers stored in storage locations in the microprocessor of Fig. 23 for Example 3 of an analog-to-digital conversion for six sampling times in the RANGE sampling routine of Figure 22 for the two per unit line cycle;

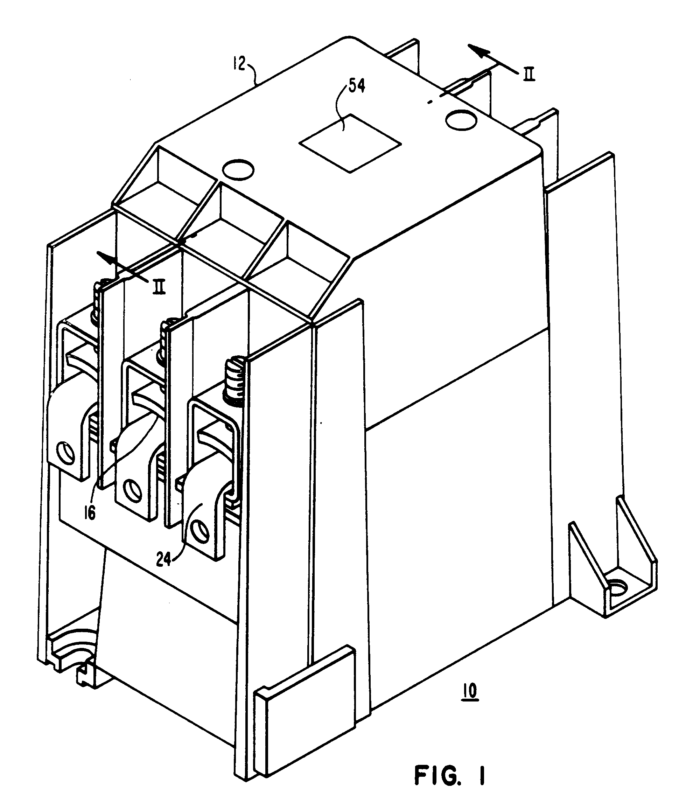

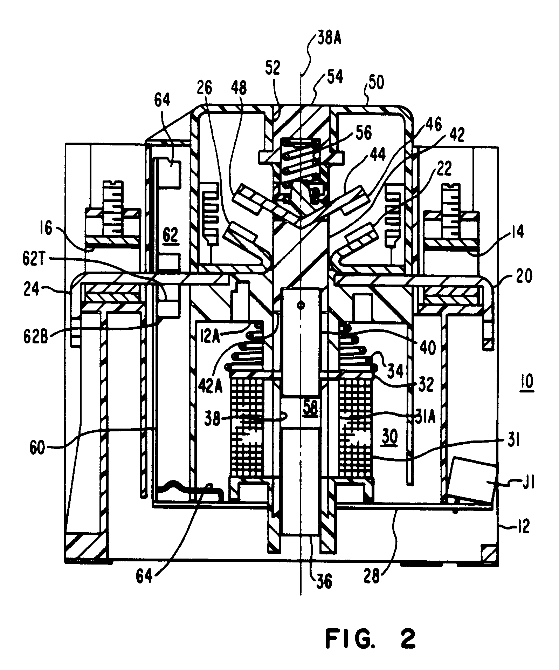

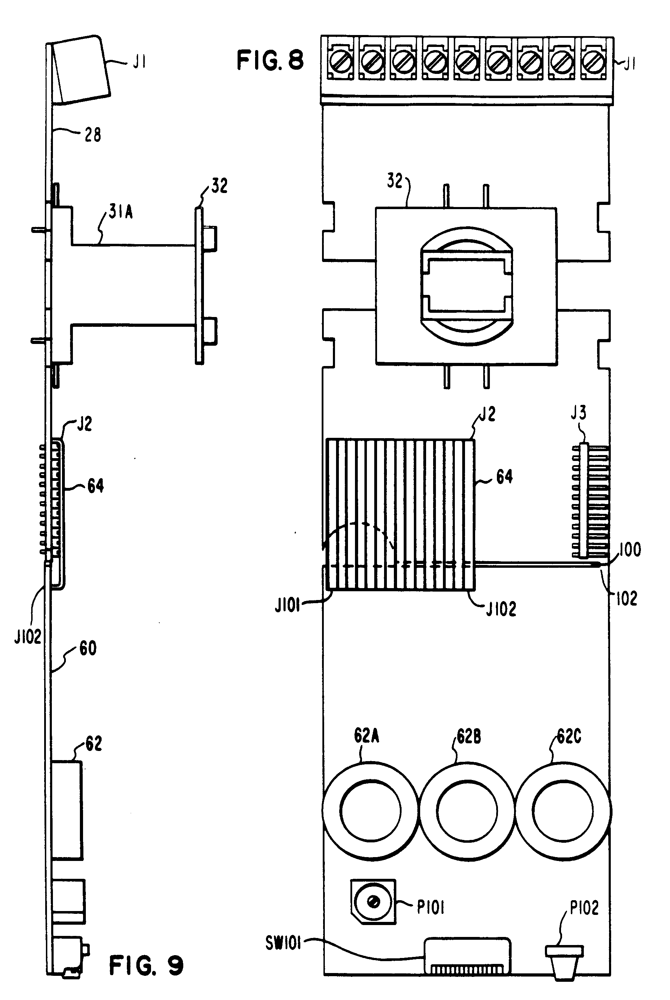

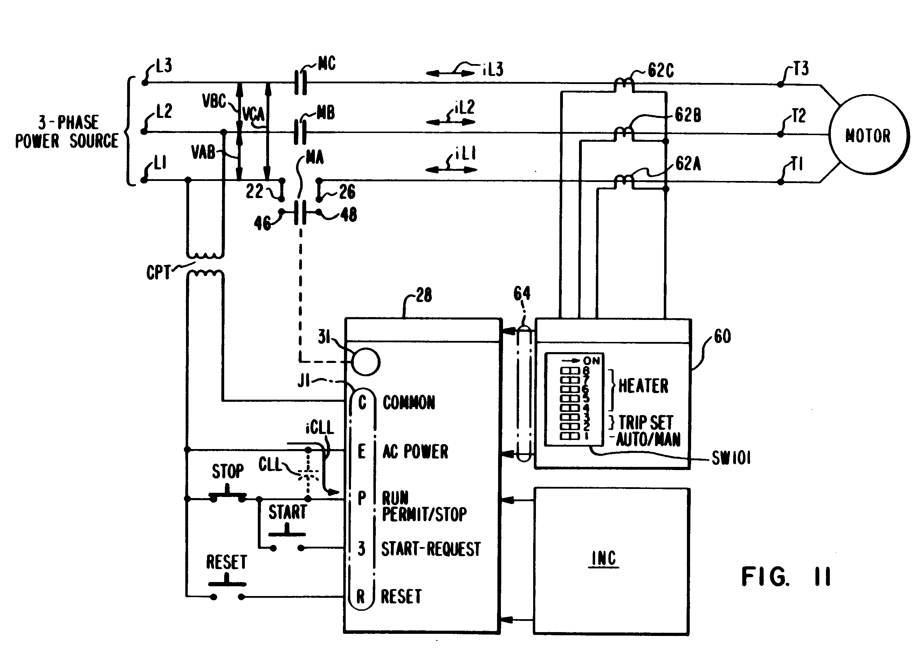

Figs. 1 and 2 show a three phase electrical contactor or controller 10. For the purpose of simplicity of illustration the construction features of only one of the three poles will be described it being understood that the other two poles are the same. Contactor 10 comprises a housing 12 made of suitable electrical insulating material such as glass/nylon composition upon which are disposed electrical load terminals 14 and 16 for interconnection with an electrical apparatus, a circuit or a system to be serviced or controlled by the contactor 10. Such a system is shown schematically in Fig. 11, for example. Terminals 14 and 16 may each form part of a set of three phase electrical terminals as mentioned previously. Terminals 14 and 16 are spaced apart and interconnected internally with conductors 20 and 24, respectively, which extend into the central region of the housing 12. There, conductors 20 and 24 are terminated by appropriate fixed contacts 22 and 26, respectively. Interconnection of contacts 22 and 26 will establish circuit continuity between terminals 14 and 16 and render the contactor 10 effective for conducting electrical current therethrough. A separately manufactured coil control board 28 (as shown hereinafter in Figs. 8, 9 and 10) may be securely disposed within housing 12 in a manner to be described hereinafter. Disposed on the coil control board 28 is a coil or solenoid assembly 30 which may include an electrical coil or solenoid 31 disposed as part thereof. Spaced away from the coil control board 28 and forming one end of the coil assembly 30 is a spring seat 32 upon which is securely disposed one end of a kickout spring 34. The other end of the kickout spring 32 resides against portion 12A of base 12 until movement of carrier 42 in a manner to be described hereinafter causes bottom portion 42A thereof to pick up spring 34 and compress it against seat 32. This occurs in a plane outside of the plane of Fig. 2. Spring 34 encircles armature 40. It is picked up by bottom portion 42A where they intersect. The dimension of member 42 into the plane of Fig. 2 is larger than the diameter of the spring 34. A fixed magnet or slug of magnetizable material 36 is strategically disposed within a channel 38 radially aligned with the solenoid or coil 31 of the coil assembly 30. Axially displaced from the fixed magnet 36 and disposed in the same channel 38 is a magnetic armature or magnetic flux conductive member 40 which is longitudinally (axially) movable in the channel 38 relative to the fixed magnet 36. At the end of the armature 40 and spaced away from the fixed magnet 36 is the longitudinally extending electrically insulating contact carrier 42 upon which is disposed an electrically conducting contact bridge 44. On one radial arm of contact bridge 44 is disposed a contact 46, and on another radial arm of contact bridge 44 is disposed a contact 48. Of course, it is to be remembered that the contacts are in triplicate for a 3 pole contactor. Contact 46 abuts contact 22 (22-46), and contact 48 abuts contact 26 (26-48) when a circuit is internally completed between the terminal 14 and terminal 16 as the contactor 10 closes. On the other hand, when the contact 22 is spaced apart from the contact 46 and the contact 26 is spaced apart from contact 48, the internal circuit between the terminals 14 and 16 is open. The open circuit position is shown in Fig. 2. There is provided an arc box 50 which is disposed to enclose the contact bridge 44 and the terminals 22, 26, 46 and 48, to thus provide a partially enclosed volume in which electrical current flowing internally between the terminals 14 and 16 may be interrupted safely. There is provided centrally in the arc box 50 a recess 52 into which the crossbar 54 of the carrier 42 is disposed and constrained from moving transversely (radially) as shown in Fig. 2, but is free to move or slide longitudinally (axially) of the center line 38A of the aforementioned channel 38. Contact bridge 44 is maintained in carrier 42 with the help of a contact spring 56. The contact spring 56 compresses to allow continued movement of the carrier 42 towards slug 36 even after the contacts 22-46 and 26-48 have abutted or "made". Further compression of contact spring 56 greatly increases the pressure on the closed contacts 42-46 and 26-48 to increase the current-carrying capability of the internal circuit between the terminals 14 and 16 and to provide an automatic adjustment feature for allowing the contacts to attain an abutted or "made" position even after significant contact wear has occurred. The longitudinal region between the magnet 36 and the movable armature 40 comprises an air gap 58 in which magnetic flux exists when the coil 31 is electrically energized.

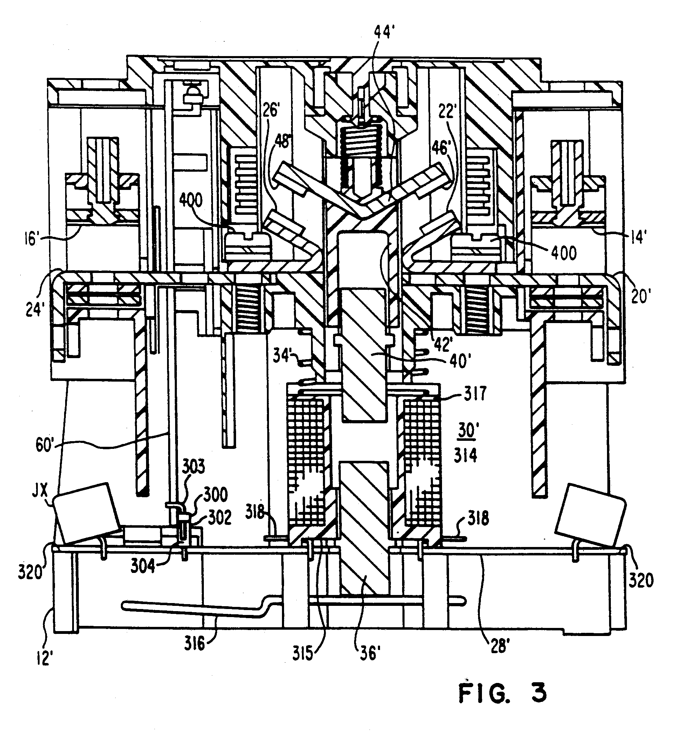

Externally accessible terminals on a terminal block J1 may be disposed upon the coil control board 28 for interconnection with the coil or solenoid 31, among other things, by way of printed circuit paths or other conductors on the control board 28. Another terminal block JX (shown in Fig. 3) may also be disposed on printed circuit board 28 for other useful purposes. Electrical energization of the coil or solenoid 31 by electrical power provided at the externally accessible terminals on terminal block J1 and in response to a contact closing signal available at externally accessible terminal block J1 for example, generates a magnetic flux path through fixed magnet or slug 36, the air gap 58 and the armature 40. As is well known, such a condition causes the armature 40 to longitudinally move within the channel 38 in an attempt to shorten or eliminate the air gap 58 and to eventually abut magnet or slug 36. This movement is in opposition to, or is resisted by, the force of compression of the kickout spring 34 in initial stages of movement and is further resisted by the force of compression of the contact spring 56 after the contacts 22-46 and 26-48 have abutted at a later portion of the movement stroke of the armature 40.

There may also be provided within the housing 12 of the contactor 10 an overload relay printed circuit board or card 60 (also shown in Figs. 8, 9 and 10) upon which are disposed current-to-voltage transducers or transformers 62 (only one of which 62B is shown in Fig. 2). In those embodiments of the invention in which the overload relay board 60 is utilized, the conductor 24 may extend through the toroidal opening 62T of the current-to-voltage transformer or transducer 62B so that current flowing in the conductor 24 is sensed by the current-to-voltage transformer or transducer 62B. The information thus sensed is utilized advantageously in a manner to be described hereinafter for providing useful circuit information for the contactor 10.

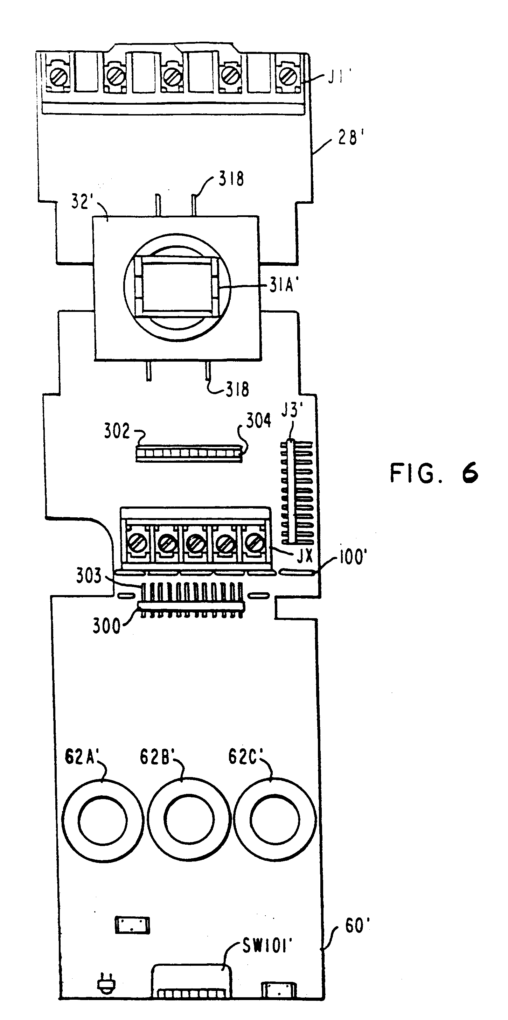

There may be also provided at one end of the overload relay board 60, selector switches 64, which may be accessible from a region external of the housing 12 Another embodiment of the invention is depicted on Fig. 3 and Fig. 6 the description of which and operation of which will be provided hereinafter.

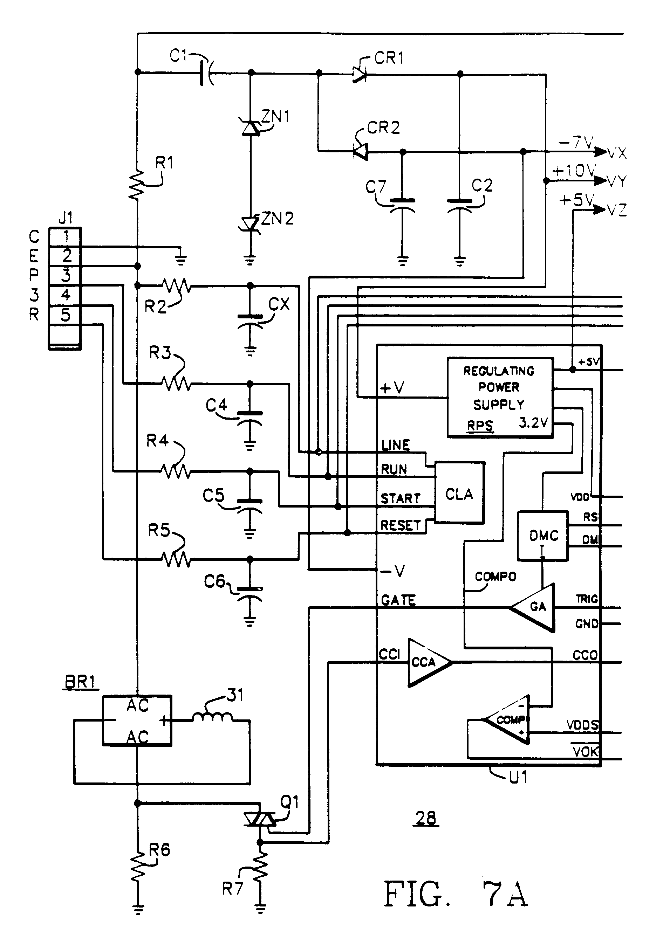

Referring now to Figs. 7A through 7D, an electrical block diagram for the control circuit of the present invention is shown. Coil control card 28 of Figs. 2, 8, 9 and 10 has provided thereon the terminal block or strip J1 for connection with external control elements such as shown in Fig. 11 for example. Terminal block J1 has terminals 1 through 5 with designations "C", "E", "P", "3", and "R", respectively. Connected to terminal "2" is one end of resistive element R1, one end of a resistive element R2, and the first AC input terminal of a full-wave bridge rectifier BR1. The other end of resistive element R1 is connected to one end of a capacitive element C1, and one end of a resistive element R16. This latter electrical point is designated "120 VAC". The other end of the resistive element R2 is the "LINE" input terminal of a bipolar linear, custom, analog, integrated circuit module U1, the function of which will be described hereinafter. This latter terminal is also connected to the B40 terminal of a microprocessor U2 and to one side of a capacitance element CX, the other side of which is grounded. Microprocessor U2 may be the kind manufactured by "Nippon Electric Co." and identified as $\mu$PD75CG33E or the kind identified as $\mu$PD7533. Connected to the second AC input terminal of the bridge rectifier BR1 are one side of a resistive element R6, the other side of which is system grounded and the anode of a TRIAC or similar gated device Q1. The other end of the capacitive element C1 is connected to the anode of a diode CR1, the cathode of a diode CR2 and the regulating terminal of a Zener diode ZN1. The cathode of the diode CR1 is connected to one side of a capacitive element C2, the other side of which is system grounded, and to the "+V" terminal of the integrated circuit U1. This latter point represents the power supply voltage VY and in the preferred embodiment of the invention is +10VDC. The anode of the diode CR2 is connected to one side of a capacitive element C7, the other side of which is grounded. The other terminal of the Zener diode ZN1 is connected to the non-regulating terminal of another Zener diode ZN2. The other side or regulating terminal of the Zener diode ZN2 is grounded. The junction between the anodes of the device CR2 and the capacitive element C7 carries the power supply voltages VX which in a preferred embodiment of the invention is designated -7V DC.

Input terminal "1" on terminal board J1 is grounded. Input terminal "3" on terminal board J1 is connected to one side of a resistive element R3, the other side of which is connected to one side of a capacitive element C4, to the "RUN" input terminal of the linear integrated circuit U1 and to the B41 terminal of the microprocessor U2. The other side of the capacitive element C4 is grounded. Terminal "4" of terminal board J1 is connected to one side of a resistive element R4, the other side of which is connected to one side of a capacitive element C5, the "START" input terminal of the linear circuit U1 and to the B42 terminal of the microprocessor U2. The other side of the capacitive element C5 is connected to ground. Input terminal "5" of the terminal board J1 is connected to one side of a resistive element R5, the other side of which is connected to one side of capacitive element C6, the "RESET" input terminal of the linear integrated circuit U1 and to the B43 terminal of the microprocessor U2. The other side of the capacitive element C6 is connected to ground. The combination of resistive and capacitor elements R3-C4, R4-C5, and R5-C6 represent filter networks for the input terminals "3", "4" and "5" of terminal board J1, respectively. These filters in turn feed high impedance circuits represented by the inputs "RUN", "START" and "RESET", respectively, of the linear integrated circuit U1.

Across the DC or output terminals of the full wave bridge rectifier BR1 is connected the aforementioned solenoid coil 31 to be used in a manner previously described and further described hereinafter. The other main conduction terminal or cathode of the silicon-controlled rectifier or similar gated device Q1 is connected to one side of a resistive element R7 and to the "CCI" terminal of the device U1. The other side of the resistive element R7 is grounded. The gate of the silicon-controlled rectifier or similar gated device Q1 is connected to the "GATE" output terminal of the linear integrated circuit U1.

The linear integrated circuit U1 has a "+5V" power supply terminal which is designated VZ and which is connected to the REF input terminal of the microprocessor U2, and a resistive potentiometer element R8 for adjustment. The integrated circuit module U1 has an output terminal "VDD" which is connected to the VDD input terminal of the microprocessor U2, to one side of a capacitive element C16 and to one side of a resistive element R15, the other side of which is connected to one side of a capacitive element C9 and to the "VDDS" input terminal of the linear analog module U1. The other sides of the capacitive elements C9 and C16 are grounded. The linear integrated circuit module U1 also has a ground terminal "GND" which is connected to the system common or ground. Integrated circuit U1 has a terminal "RS" which supplies the "RES" signal to the RES input terminal of the microprocessor U2. Linear integrated circuit module or chip U1 has a terminal "DM" (DEADMAN) which is connected to one side of a capacitive element C8 and to one side of a resistive element R14. The other side of the resistive element R14 is connected to the 022 terminal of the microprocessor U2. The other side of the capacitor element C8 is connected to ground. Chip or circuit U1 has a "TRIG″" input terminal upon which the signal "TRIG" is supplied from the B52 terminal of the microprocessor U2. Integrated circuit U1 has a "$\overline{VOK}$" output terminal which provides the signal "$\overline{VDDOK}$" to the INTO terminal of the microprocessor U2. Finally, integrated circuit U1 has a "CCO" output terminal which provides the signal "COILCUR" to the AN2 input terminal of the microprocessor U2. Signal "COILCUR" carries an indication of the amount of coil current flowing in coil 31. Further description of the internal operation of the bipolar linear integrated circuit U1 and the operation of the variously described inputs and outputs will be provided hereinafter.

The other side of resistive element R16 is connected to the anode of a diode CR4, the cathode of which is connected to one side of a capacitive element C13, one side of a resistive element R17 and the AN3 input terminal of the microprocessor U2. The latter terminal receives the signal "LVOLT" which is indicative of line voltage for the system under control. The other side of the capacitive element C13 and the other side of the resistive element R17 are system grounded.

There is also provided on the coil control board 28 another connector or terminal block J2 having terminals upon which the following signals or functions are provided "GND" (connected to ground), "MCUR" (an input), "DELAY" (an input), "+5V" (power supply), "+10V" (power supply) and "-7V" (power supply). The control signals $\overline{Z}$, A, B, C and SW are also provided here.

The following terminals of the microprocessor U2 are grounded: GND and AGND. The terminal AN2 of the microprocessor U2 is connected to the "MCUR" terminal of the terminal board J2. Terminal CL2 of microprocessor U2 is connected to one side of a crystal Y1, the other side of which is connected to terminal CL1 of the microprocessor U2. Terminal CL2 is also connected to one side of the capacitive element C14. Terminal CL1 is also connected to one side of capacitive element C15. The other sides of the capacitive elements C14 and C15 are connected to system ground. Terminal DVL of microprocessor U2 is connected to the "+5V" terminal on terminal board J2.

The linear analog circuit U1 internally includes a regulated power supply RPS, the input of which is connected to the "+V" input terminal and the output of which is connected to the "+5V" output terminal. In a preferred embodiment of the invention, the unregulated 10 volt value VY is converted within the regulated power supply RPS to the highly regulated 5 volt signal VZ or +5V. In addition, an internal output line COMPO for the regulated power supply RPS which in a preferred embodiment of the invention may be 3.2 volts is supplied to the reference terminal (-) of a comparator COMP. One input (+) of the comparator COMP is provided with the VDDS signal. The output of the comparator COMP is is designated $\overline{VOK}$. The input terminals designated "LINE", "RUN", "START" and "RESET" are connected to a clipping and clamping circuit CLA in the linear integrated circuit U1 which in a preferred embodiment of the invention limits the range of the signal supplied to the microprocessor U2 to between +4.6 volts positive and -.4 volts negative regardless of whether the associated signal is a DC voltage or an alternating voltage signal. Internal of the linear circuit U1 is a gate amplifier circuit GA which receives its input from the "TRIG" input and supplies the GATE output. Furthermore, a DEADMAN and reset circuit DMC which is interconnected to receive the DEADMAN signal "DM" and to provide the reset signal RES at "RS" also provides an inhibit signal for gate amplifier GA at "I" such that the gate amplifier GA will produce no gating signal GATE if the DEADMAN function is occurring. There is also provided a coil current amplifier CCA which receives the coil current signal from terminal "CCI" and provides the output signal COILCUR at terminal CCO for utilization by the microprocessor U2 in a manner to be described hereinafter. The description of the functions provided by the microprocessor U2 at the various input and output terminals thereof will be described hereinafter.

There is also provided the overload relay board 60 which includes a connector J101 and connector J102 which are complementary with and connectable to the connector J2 on coil current control board 28 by way of a cable 64. The previously-mentioned current-to-voltage transducer former 62 may be represented by three transformers 62A, 62B and 62C, respectively for a three-phase electrical system which is controlled by the overload relay board 60. One side of each of the secondary windings of these current-to-voltage transducers 62A, 62B and 62C is grounded while the other side is connected to one side of a resistive element R101, R102 and R103, respectively. There is also provided a triple two-channel analog multiplexer/demultiplexer or transmission gate U101 having terminals aOR, bOR and cOR connected to the other sides of resistive elements R101, R102 and R103, respectively. The ay, by and cy terminals of gate U101 are connected to ground. Terminals ax, bx and cx of gate U101 are all tied together electrically and connected to one side of an integrating capacitor C101 and the anode of a rectifier CR101. The other side of the capacitor C101 is connected to the cathode of a rectifier CR102, the anode of which is connected to the cathode of the aforementioned rectifier CR101, to the output of a differential amplifier U103 and to the bOR terminal of a second triple two-channel analog multiplexer/demultiplexer U102. The other side of the integrating capacitor C101 is also connected to the positive input terminal of a buffer amplifier with gain U105 and to the cOR output termi al of the aforementioned second analog multiplexer/demultiplexer or transmission gate U102. The aforementioned joined terminals ax, bx and cx of transmission gate U101 are also connected to the ay and cx terminals of the transmission gate U102. The ax terminal of the transmission gate or analog multiplexer/demultiplexer U102 is connected to ground. The aOR terminal of the device U102 is connected to one side of a capacitive element C102, the other side of which is connected to the bx terminal of the multiplexer/demultiplexer U102 and to the negative input terminal of the aforementioned differential amplifier U103. The positive input terminal of the aforementioned differential amplifier U103 is grounded. The negative input terminal of the differential amplifier U105 is connected to the wiper of a potentiometer P101, one main terminal of which is grounded and the other main terminal of which is connected to provide the "MCUR" output signal to the terminal board J102. This latter signal is provided from one side of a resistive element R103, the other side of which is connected to the output of the differential amplifier U105, the anode of a diode CR104 and the cathode of a diode CR105. The anode of the diode CR105 is connected to ground and the cathode of the diode CR104 is connected to the +5V power supply terminal VZ. Devices U101, U102 and U103 are supplied from the -7 power supply. The +10V power supply voltage is supplied to the aforementioned amplifier-with-gain U105 and to one side of a resistive element 104, the other side of which is connected to supply power to the aforementioned transmission gates U101 and U102 as well as the anode of a diode CR106, the cathode of which is connected to the +5V power supply voltage. The +5V power supply level VZ on terminal board J102 is also supplied to one side of filter capacitive element C103, the other side of which is grounded and to one main terminal of a potentiometer P102, the other main terminal of which is grounded. The wiper of the potentiometer P102 is connected to provide the "DELAY" output signal on terminal board J101 and thence to terminal ANO of microprocessor U2. The control terminals A, B and C of the aforementioned analog multiplexer/demultiplexer device U101 are connected to the A, B and C signal terminals, respectively, of a parallel to serial eight-bit static shift register U104. Signals A, B and C come from terminals 032, 031 and 030, respectively, of microprocessor 42.

There is provided an eight-pole switch SW101 with the following designations: AM, CO, C1, SP, HO, H1, H2, and H3. One end of each of the switch poles is grounded while the other end of each is connected to the 5 volt power supply VZ by way of the P0 through P7 input terminals of the parallel to serial eight-bit static shift register U104, the "COM" output terminal of which receives the "SW" signal from terminal board J101 and the terminal I10 of microprocessor U2. The previously described designations "H0" through "H3" represent "heater" classes for the types of devices controlled by the overload relay board 60. Proper manipulation of any or all of the latter four poles in switch SW101 provides a convenient way to represent the heater class of the device protected by the overload relay board 60.

Referring now to Figs. 2, 8, 9 and 10, construction features of the printed circuit board which is utilized to make the coil control board 28 and the overload relay board 60 are illustrated and described. In particular, the terminal block J1 is shown disposed upon the coil control board 28. Also shown disposed upon the coil control board 28 is the coil assembly 30 (without coil). The coil control assembly 30 includes the spring seat arrangement 32 and a coil seat arrangement 31A. There is also disposed on the coil control board 28 the connector J2 into which is soldered or otherwise disposed one end of the flat ribbon cable 64. Flat ribbon cable 64 is terminated at the other end there of at the connectors J101 and J102 on the overload relay board assembly 60. The three-phase current transducers or transformers 62, depicted as 62A, 62B, 62C in Fig. 8 for three-phase electrical current, are shown on the overload relay board 60. There is provided the switch SW101 which is an 8-pole dip switch. Also shown are the potentiometers P101 and P102 for factory calibration and time delay adjustment, respectively.

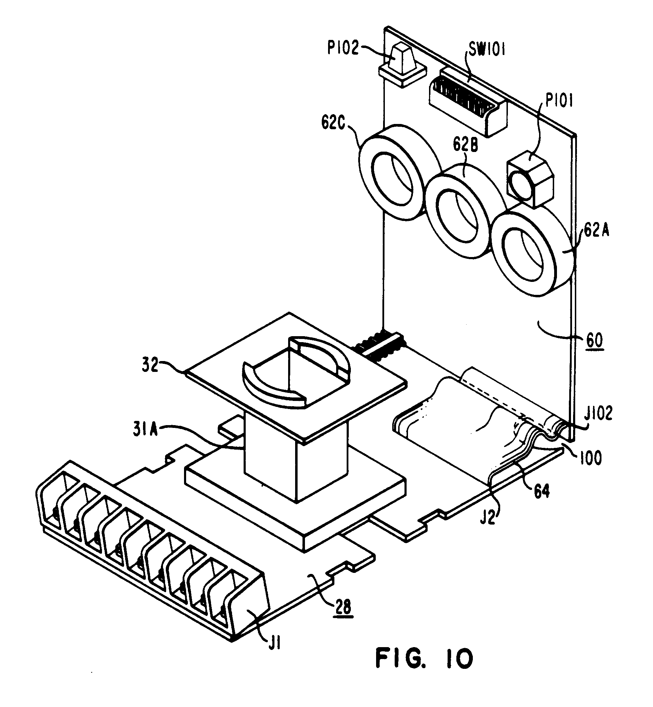

In a preferred embodiment of the invention, the coil control board 28 and the overload relay board 60 may be formed on one piece of preshaped, soldered and connected printed circuit board material. The single piece of printed circuit board material is then separated at region 100 by breaking the isthmus 102, for example, to form a hinged right angle relationship between the overload relay board 60 and the coil control board 28, depicted best in Figs. 2 and 10.

Referring now to Fig. 2 and Fig. 11, an illustration and exemplary but non-limiting control arrangement utilizing the apparatus and electrical elements of the coil control board 28 and the overload relay board 60 is shown. In particular, there are provided three main power lines--L1, L2, L3--which provide three-phase AC electrical power from a suitable three phase power source. These lines are fed through contactors MA, MB, MC respectively. The terminal board J1 is shown with its terminals designated: "C", "E", "P", "3" and "R". These designations represent the functions or connections: "COMMON", "AC POWER", "RUN PERMIT/STOP", "START-REQUEST", and "RESET", respectively. As was shown with respect to Figs. 8, 9, 10 for example, the coil control board 28 communicates with the overload relay board 60 by way of the multipurpose cable 64. The overload relay board 60 has, among other things, the switch SW101 thereon which performs the functions described previously. In addition, the secondary windings of the current transducers or transformers 62A through 62C are shown interconnected with the overload relay board 60. The transducers 62A through 62C monitor the instantaneous line currents iL1, iL2 and iL3 in lines L1, L2, L3, respectively, which are drawn by a MOTOR interconnected with the lines L1, L2, L3 by way of terminals T1, T2, T3, respectively. Power is provided to the coil control board 28 and the overload relay board 60 by way of a transformer CPT, the primary winding of which is connected across lines L1, L2, for example. The secondary winding thereof is connected to the "C" and "E" terminals of the terminal board J1. One side of the secondary winding of the transformer CPT may be interconnected to one side of a normally closed STOP pushbutton and one side of a normally open RESET pushbutton. The other side of the STOP pushbutton is connected to the "P" input terminal of the J1 terminal board and to one side of a normally opened START pushbutton. The other side of the normally open START pushbutton is connected to the "3" input terminal of the terminal board J1, The other side of the RESET pushbutton is connected to the reset terminal R of the terminal board J1. The aforementioned pushbuttons may be manipulated in a manner well known in the art to provide control information to the coil control board 28 and overload relay board 60.

Referring now to Figs. 2, 7C and 12 through 18, the construction and operation features of various kinds of current transformers or transducers 62 are described. Conventional prior art current sensing transformers produce a secondary winding current which is proportional to the primary binding current. When an output current signal from this type of transformer is fed to a resistive current shunt and voltage across the shunt is provided to a voltage-sensing electronic circuit such as might be found in the overload relay board 60, a linear relationship between input and output exists. This voltage source then can be utilized for measurement purposes. On the other hand, air-core type transformer, sometimes called liner couplers, may be used for current-sensing applications by providing a voltage across the secondary winding which is proportional to the derivative of the current in the primary winding. The conventional iron-core current transformer and the linear coupler have certain disadvantages. One is that the "turns-ratio" of the conventional transformer must be varied to change the output voltage for a given current transformer design. In the current transformers or transducers described with respect to the present invention, the rate of change with respect to time of the magnetic flux in the magnetic core of the transducer is proportional to the current in the primary winding absent flux saturation in the core. An output voltage is produced which is proportional to the derivative of the current in the primary winding, and the ratio of the output voltage to current is easily changed for various current-sensing applications. Iron core transformers tend to be relatively large. The transformer of the present invention may be miniaturized.

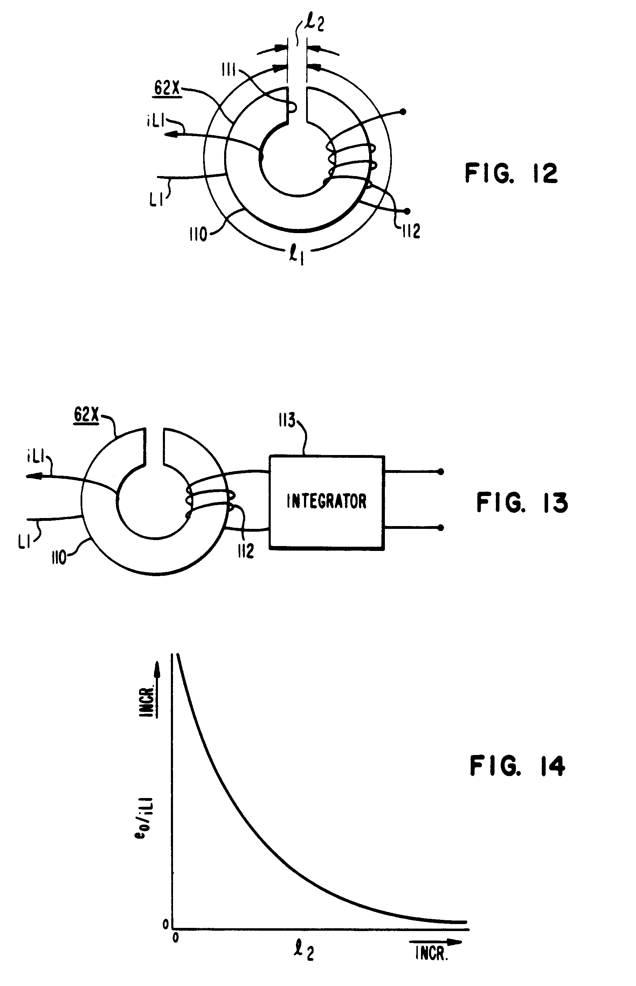

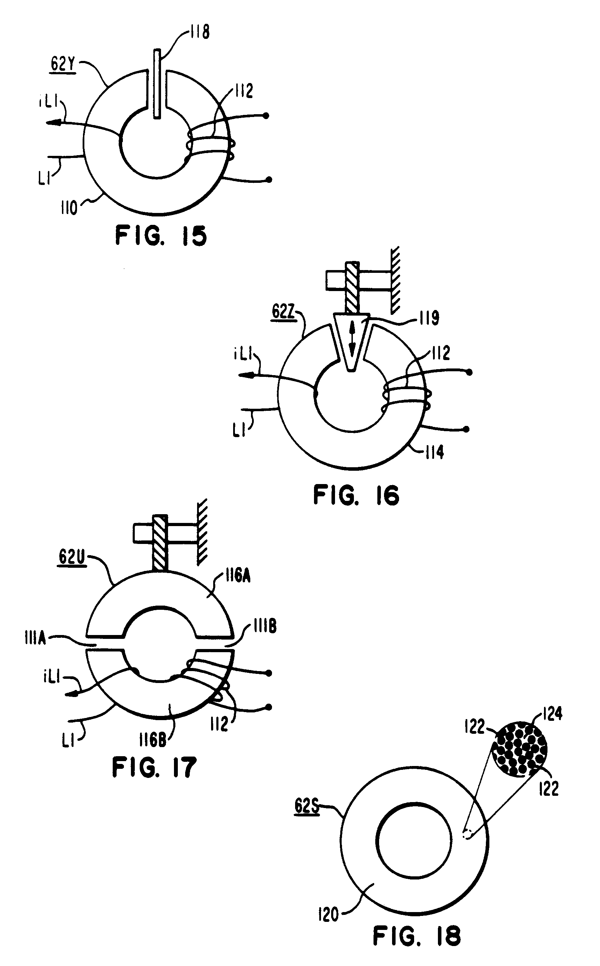

Referring specifically to Fig. 12, a transformer 62X may comprise a toroidal magnetic iron core 110 with a substantial discrete air gap 111. The primary current iL1, i.e., the current to be sensed, passes through the center of the core 110 and hence provides a single turn input primary winding for the line L1. The secondary winding 112 of the transformer 62X comprises multiple turns which may, for the purposes of illustration, be designated as having N2 turns. The secondary winding 112 has sufficient turns to provide a voltage level which is sufficient to drive electronic circuitry which monitors the transformer or transducer. The circumferential length of the iron core 110 is arbitrarily chosen for purposes of illustration as $l_1$ and the length of the air gap 111 is arbitrarily chosen as $l_2$. The cross-sectional area of the core is designated $A_1$ and the cross-sectional area of the air gap is designated $A_2$. The output voltage of the transformer is varied by changing the effective length of the air gap $l_2$. This can be accomplished by either inserting metallic shims into the air gap 111 as is shown in Figs. 15 and 16, or by moving separate portions of the core structure of the transformer as shown in Fig. 17, to provide a relatively smaller or larger air gap 111. Once the length of the air gap 111 has been chosen, a relatively small current-sensing transformer or transducer is formed which produces an output voltage $e_0(t)$ which is generally proportional to the derivative of the input current iL1 in the input winding of the transformer. One advantage of this arrangement is that it is not limited to use on sinusoidal or even periodic input currents. However for purposes of simplicity of illustration the following will be described with a sinusoidal input current. The output voltage $e_0(t)$ produced by the secondary winding of the transformer or transducer 62X shown in Fig. 12, for example, is given by Equation (1):

$$e_0(t) = \frac{N1 \; N2}{\dfrac{l_1}{\mu_1 A_1} + \dfrac{l_2}{\mu_2 A_2}} \; \frac{d}{dt} \; (I_{L1} \; Sin \; \omega t) \qquad (1)$$

The terms $\mu_1$ and $\mu_2$ are the magnetic permeability of the core 110 and air gap 111, respectively. $\omega$ - (omega) is the frequency of the instantaneous current iL1 and $I_{L1}$ equals the peak magnitude of the instantaneous current iL1. For applications where all parameters remain constant except the length of the air gap $l_2$ and the applied frequency $\omega$, equation (1) reduces to equation (2):

$$e_0(t) = \frac{N1 \; N2}{k_1 + k_2 \ell_2} \; [\omega I_{L1} \; Cos \; \omega t] \qquad (2)$$

where the bracketed term is equivalent to the derivative portion of Equation (1).

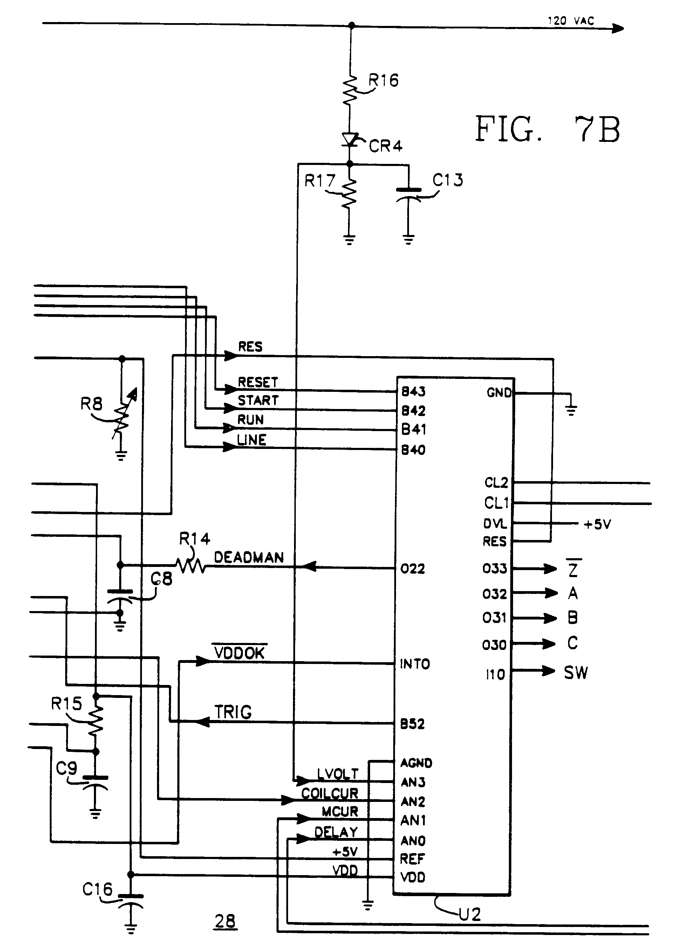

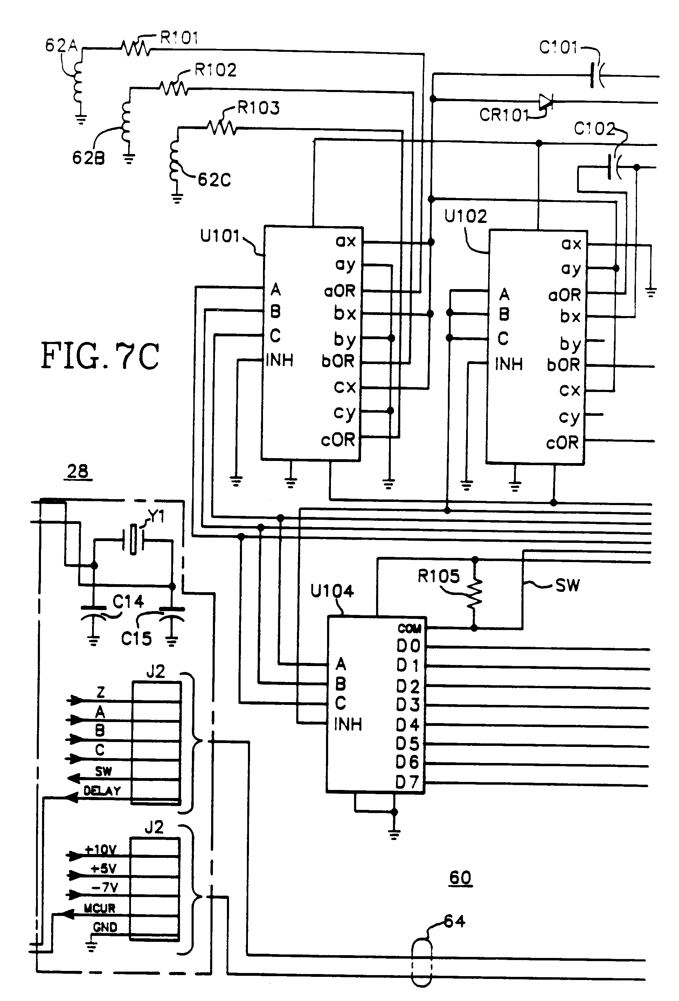

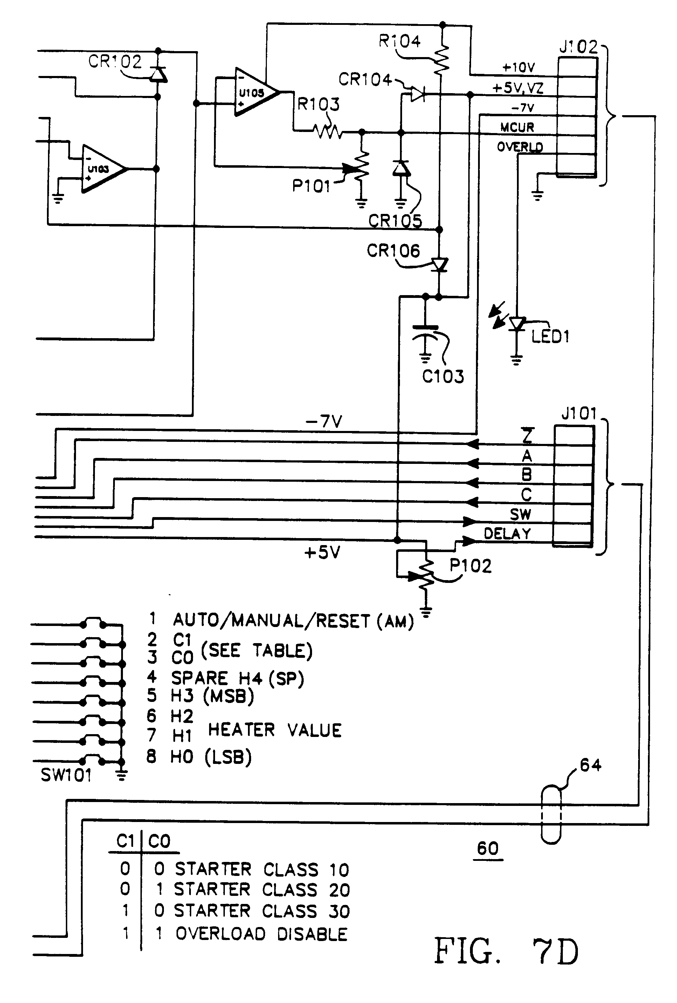

If the voltage $e_0(t)$ of equation (2) is supplied to the terminals of an integrating circuit or integrator such as 113 shown in Fig. 13 which, in a preferred embodiment of the invention, may be as shown in Fig. 7, equation (3) applies at the output of the integrator 113.

$$e_0{}'(t) = \frac{N1 \; N2}{k_1 + k_2 \ell_2} \; I_{L1} \; Sin \; \omega t \qquad (3)$$

As the length $l_2$ of the air gap 111 is varied, the output voltage $e'_0(t)$ which is now directly proportional to the input current iL1 will vary in inverse proportion to the length $l_2$ of the air gap 111. Fig. 14 shows a typical plot of the output voltage $e'_0(t)$ divided by the input current (iL1 for example) for variations in the length 111 of the air gap $l_2$. In a special case where the primary frequency w remains constant or is assumed to be constant, the use of the integrating circuit or integrator 113 of Fig. 13 may be eliminated. In this case, equation (2) can then be depicted as shown in equation (4).

$$e_0(t) = \frac{k4}{k_1 + k_2 l_2} \; I_{L1} \; Cos \; \omega t \qquad (4)$$

9

where the constant frequency term $\omega$ forms part of k4. In this case the output $e_0(t)$ from the transformer secondary winding 112 is proportional to the input current $I_{L1}$ andvaries inversely with the length $l_2$ of the air gap 111.

Referring specifically to Figs. 15, 16, 17, in applications There it is desirable to use the same current transformer or transducer for sensing several ranges of current, the output voltage $e_0(t)$ may be varied by effectively changing the length $l_2$ of the air gap 111. This is accomplished by inserting a shim in the air gap of the transformer 62Y of predetermined width, depending upon the range of output voltage $e_0(t)$ desired. Alternately, a wedge-shaped semicore 119 may be inserted into the air gap 111 of the transformer 62Z for accomplishing the same purpose; and finally, the core of the transformer may be cut into two sections--116A, 116B--for the transformer 62U of Fig. 17 to accomplish the same purpose, by providing two complementary air gaps 111A, 111B. Figures 12-17 teach a current-to-voltage transformer which has a primary winding disposed on a magnetic core for providing magnetic flux in the magnetic core in general proportion to the amount of electrical current flowing in the primary winding. The magnetic core has a discrete but variable air gap. The discrete but variable air gap has a first magnetic reluctance which prevents magnetic saturation of the magnetic core for values of electrical current which are less than or equal to a value I1. There is also provided a secondary winding which is disposed on the magnetic core for producing an electrical voltage V at the output terminals thereof which is generally proportional to the magnetic flux in the magnetic core. Voltage V is less than or equal to voltage V2 for the first magnetic reluctance and for values of current I less than or equal to I1. The variable but discrete air gap is changeable to provide a second and higher value of air gap reluctance which prevents magnetic saturation of the magnetic core for values of electrical current I less than or equal to I2 where I2 is greater than I1. The voltage V remains less than or equal to V1 for the second value of air gap reluctance and for values of current less than or equal to I2.

However, according to the invention and referring specifically to Fig. 18, a homogeneous magnetic core 120 for a transformer 62S may be provided which apparently has no large discrete air gap 111, but which, in fact, is comprised of sintered or compressed powdered metal such as but not limited to ferrite in which microscopic clumps or quantrums of magnetically conductive core material 122 with homogeneously or evenly distributed air gaps 124. This has the same effect as a discrete air gap such as 111 shown in Fig. 12 but reduces the effect of stray magnetic field influences and provides a very reliable and small transformer. This type of transformer may be formed by compressing powdered metal or otherwise forming it into a core shape which has sections of powdered metal 122 and the air gaps or interstices 124 microscopically and evenly distributed around the body thereof. Thusly constructed, the magnetic core need not saturate, thus providing an output voltage which is proportional to the mathematical derivative of the excitation current. In one embodiment of the invention, non-magnetic insulating material is disposed in the afore-mentioned interstices.

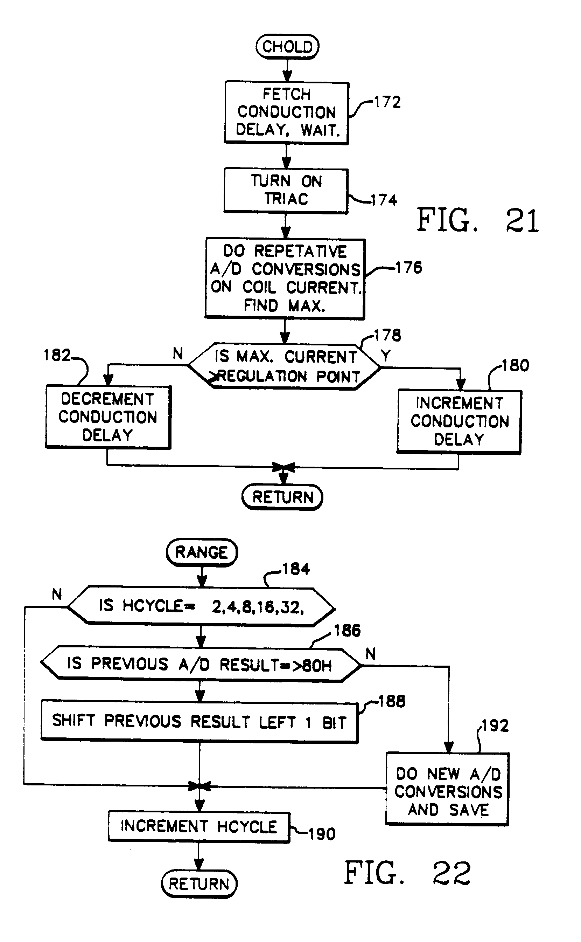

Referring now to Figs. 22, 23, 24 and 25 as well as Figs. 7A through 7D the apparatus and method for detecting and measuring line current iL1, iL2 and iL3 is taught. With regard to the transmission gate U101, its ax, bx and cx output terminals are tied together and to one side of the integrating capacitor C101. The microprocessor U2 provides signals A, B and C to the related inputs of the transmission gate U101 in accordance with the digital arrangement shown in Table 2 to control parameter selection in switch U101. The net effect of this operation is to sequentially sample the secondary winding voltage of current transformers or transducers 62A, 62B or 62C in 32 half-line cycle increments. The integrating capacitor C101 is charged in a manner to be described hereinafter. As was described previously, the output voltages across the secondary winding of the current transformer 62A, 62B and 62C are related to the mathematical differential of the line currents iL1, iL2 or iL3 flowing in the main lines A, B and C, respectively. Since this voltage is converted to a charging current by impressing it across a resistive element R101, R102 or R103 respectively, the voltage $V_{C101}$ across the integrating capacitor C101 correspondingly changes with each successive line cycle. The capacitor is not discharged until after the 32-line cycles of integration in a manner to be described hereinafter.

## TABLE 2

| U101 Logic Input | | | Current |
| C | B | A | Sensed |
| --- | --- | --- | --- |
| 1 | 1 | 0 | $i_{LA}$ |
| 1 | 0 | 1 | $i_{LB}$ |
| 0 | 1 | 1 | $i_{LC}$ |
| 0 | 0 | 0 | $i_{GRD}$ |

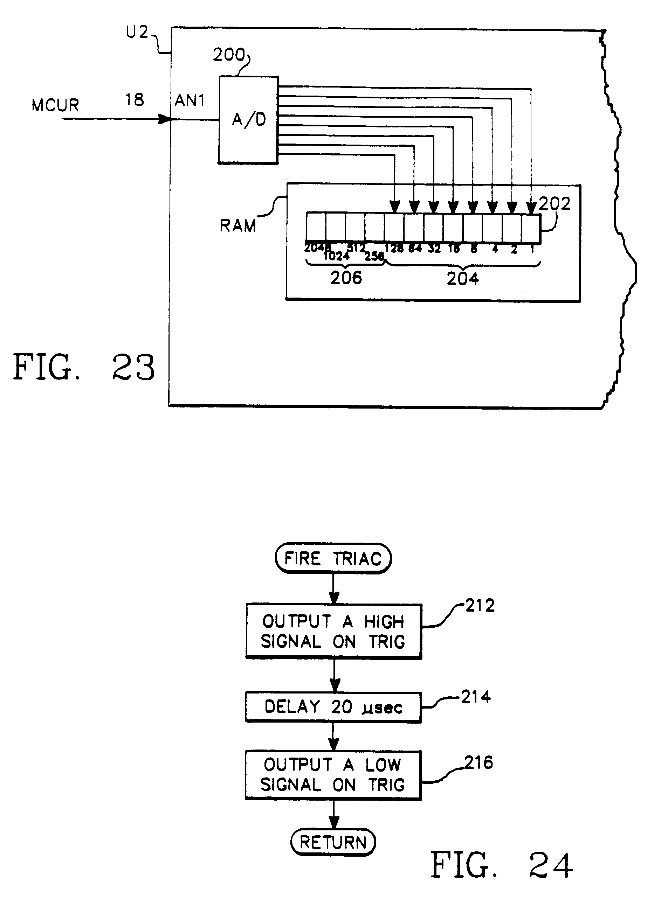

The transmission gate U102 operating in conjunction with the $\overline{Z}$ input signal rearranges the interconnection of the integrating circuitry in which the integrating capacitor C101 is placed for periodically re-initializing the circuit operation. This happens when $\overline{Z}$ = zero. The output voltage $V_{C101}$ across the integrating capacitor C101 is provided to the buffer amplifier with gain U105 for creating the signal MCUR which is provided to the AN1 input terminal of the microprocessor U2. The microprocessor U2 digitizes the data provided by the signal MCUR in a manner associated with the "RANGE" algorithm of Fig. 22. The voltage signal MCUR is provided as a single analog input to an eight-bit five-volt A-to-D (analog-to-digital) converter 200 which is an internal part of the microprocessor U2. The A-to-D converter 200 is shown in Fig. 23. It is desired to utilize the system of the present invention to be able to measure line currents which vary over a wide range depending upon the application. For example, it may be desirous in some stages to measure line currents as high as 1,200 amperes, whereas in other cases it may be desirous to measure line currents which are less than 10 amperes. In order to extend the dynamic range of the system the microprocessor U2 expands the fixed eight-bit output of the A-to-D converter 200 within the microprocessor U2 to twelve bits.

For purposes of simplicity of illustration, the previously described operation will be set forth in greater detail with illustrative examples associated with the sensing current transformer or transducer 62A and resistor R101. It is to be understood that transducer 62B and resistor R102 and transducer 62C and resistor 103 respectively could be utilized in the same manner. Further it is to be understood that

$$e_0(t) \sim \frac{di(t)}{dt}$$

is true for any current function. Presuming that the length 12 of air gap 111 in transducer 62A is fixed for a particular application (or that the transformer 62S of Fig. 18 is utilized) and presuming that i(t) is sinusoidal, i.e. $I_{L1}$ sin wt, the output voltage for the transducer as originally defined by Equation (1) may be rewritten in the form shown in Equation (5).

$$e_0(t) = \frac{K_5 \, d \, (I_{L1} \sin \omega t)}{dt} \tag{5}$$

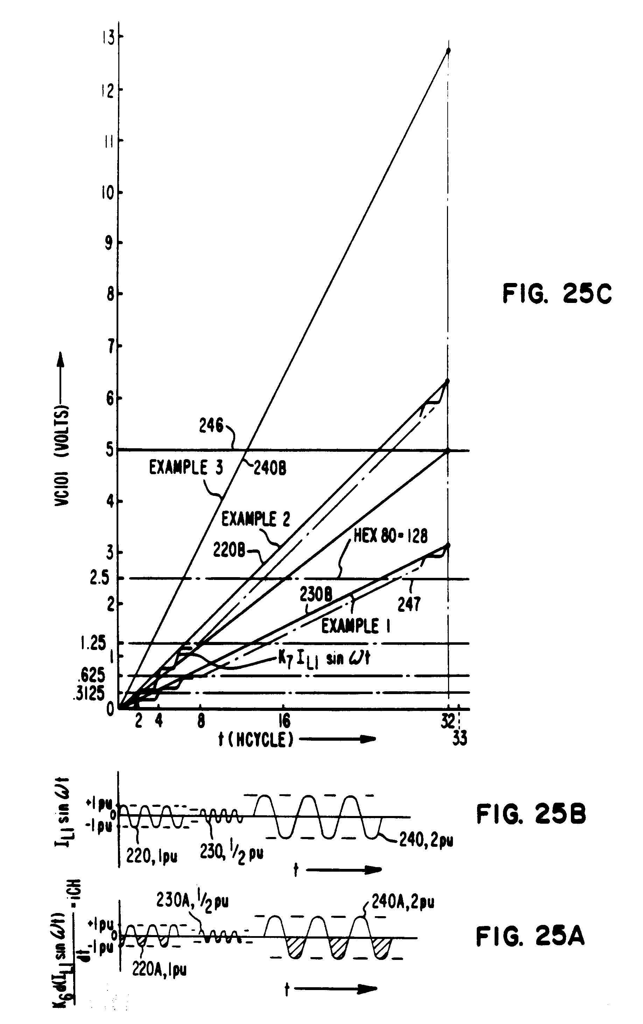

The output voltage $e_0(t)$ is impressed across the resistor R101 for conversion into a charging current iCH for the integrating capacitor C101 according to Equation (6). A plot of this expressed in per units (P.U.) is shown in Fig. 25B.

$$iCH = \frac{e_0(t)}{R101} = \frac{K_6 \, d(I_{L1} \sin \omega t)}{dt} \tag{6}$$

It is important to remember that the charging current iCH for the integrating capacitor C101 is proportional to the derivative of the line current iL1 rather than the line current itself. Consequently, as set forth in Equation (7), the voltage $V_{C101}$ across the capacitive element C101 which exists as the result of the flow of the charging current iCH(t) during negative half cycles thereof may be expressed as

$$V_{C101} = \frac{1}{C101} \quad \frac{K_6}{R101} \quad \frac{d(I_{L1} \sin \omega t) \, dt}{dt} \qquad (7)$$

$$V_{C101} = -K_7 \, I_{L1} \sin \omega t \qquad (8)$$

Equation (8) shows Equation (7) in a more simplified form. A plot of $I_{L1} \sin \omega t$ expressed in per units (P.U.) is shown in Fig. 25A; the plot of the derivative of iL1 sin wt, after integration by capacitor C101, i.e. $-K_7 \, I_{L1} \sin \omega t$ expressed in per units (P.U.) is incorporated into Fig. 25C. The current iCH for charging the capacitive element C101 comes from the output terminal ax of the transmission gate U101. This current is provided to the transmission gate U101 at the aOR input terminal and is chosen in accordance with appropriate signals on the A, B, C control terminals of the transmission gate U101 (see Table 2). In a like manner the current from the transducer 62B could have been utilized by choosing the bOR-bx terminal arrangement and the transducer 62C could have been utilized by choosing the cOR-cx terminal arrangement. Terminals ax, bx and cx are tied or connected together into a single lead which supplies charging current to integrating capacitor C101. This latter common line is interconnected with the ay and cx terminals of the transmission gate U102. The ax terminal of the transmission gate U102 is grounded and the aOR common terminal is connected to one side of a capacitor C102. The cOR terminal is connected to the other side of the capacitor C101. The bx terminal of the transmission gate U102 is connected to the negative input terminal of the operational amplifier U103 and the associated bOR common terminal is connected to the output of the operational amplifier U103. Normally, the diode arrangement CR101-CR103 is such that during the integrating operation, positive half cycles of the integrating current 1CH bypass the integrating capacitor C101 by way of the bridge arrangement which includes the diodes CR101 and CR102 and the output of the operational amplifier U103, but negative half cycles thereof charge the capacitive element C101 to the peak value of the appropriate half cycle. The capacitive element C101 is repeatedly charged to increasingly higher values of voltage, each one corresponding to the peak value of the negative half cycle of the charging current.

It is not unusual for a small voltage, in the order of .25 millivolts, to exist between the negative and positive input terminals of the operational amplifier U103. Capacitive element C102 is periodically charged to the negative of this value for creating a net input offset voltage of zero for the amplifier U103 at a charging current iCH.

Referring now to Fig. 22, Fig. 23 and Fig. 25, the "RANGE" algorithm of Fig. 22 operating in conjunction with the integrating circuit described previously which includes the capacitive element C101 and the microprocessor U2 is described with illustrative examples. It is important to remember that dynamic range for sensing line current is important. However, as is well shown in Fig. 23, the analog-to-digital converter 200 within the microprocessor U2 has a maximum input voltage beyond which a reliable digital output number cannot be guaranteed. In a preferred embodiment of the invention, the A-to-D converter 200 can accept input voltages up to 5 volts positive for producing an 8-bit signal for provision to the first eight locations, 204, of an accumulator or storage device 202 which is located in the memory of the microprocessor U2. In such a case, the maximum five volts input is represented by a decimal number of 256 which corresponds to digital ones in all eight locations of portion 204 of accumulator 202.

Fig. 25B shows a representative plot of amplitude versus time for the current $i_{L1} \sin$ wt. The plot of Fig. 25A shows the charging current iCH which is the derivative of the line current of Fig. 25B. Furthermore, Fig. 25A shows that only the negative half cycles of the current depicted therein are integrated. Convenient amplitude references 220, 230 and 240 are provided for the line current of Fig. 25B to show the difference between a 1 per unit amplitude, a $\frac{1}{2}$ per unit amplitude, and a 2 per unit amplitude respectively for the purpose of providing three illustrative Examples. Amplitudes 220A, 230A and 240A for the graph of Fig. 25A show correspondence with the per unit amplitude variations for the curve of Fig. 25B. Correspondingly, two curves or traces 230B, and 220B for Example 1 and Example 2, respectively, are shown. The 5-volt maximum input voltage line is shown at 246 in Fig. 25C. The algorithm of Fig. 22 is entered once each half cycle for 32 consecutive half cycles. Each half cycle within this interval of time is uniquely identified with a number stored as HCYCLE. Half cycles numbered 2, 4, 8, 16, and 32 identify intervals of integration each a factor of two longer than its predecessor. It is at the end of these specific intervals that the algorithm re-evaluates the voltage VC101.

Assume that the input signal is repeating each cycle during the course of the 32 intervals. Then the voltage VC101 at the end of any interval identified by HCYCLE = 2, 4, 8, 16, or 32 will be twice the size it was at the end of the preceding interval. Thus if a previous interval yielded an A/D conversion in excess of 80H, corresponding to a value of VC101 in excess of 2.5 V, it can be safely assumed that in the present interval, VC101 is in excess of 5 volts and that an A/D conversion now performed would yield an invalid result since the A/D converter is not capable of digitizing values in excess of 5 volts. Thus the algorithm, in the event that a previous result is in excess of 80H, retains that result as the best possible A/D conversion with which to proceed.

On the other hand, if a previous A/D conversion is less than 80H, it can safely be assumed that a meaningful A/D conversion can now be performed since the signal at the present time can be no greater than twice the previous value and still less than 5 volts. The advantage of replacing an earlier A/D conversion with one performed now is that the signal to be converted is twice as large and will yield more bits of resolution.

Once an A/D result in excess of 80H has been realized, it must be adjusted to account for the interval in which the A/D conversion was performed. The left shift operation 188 performs this function. For instance, a result of 80H acquired at the end of interval 4 is the result of an input signal twice as large as an input signal which yields a result of 80H at the end of interval 8. The left shift of the interval 4 result correspondingly doubles this results by the end of interval eight. At the end of thirty-two half cycles a 12 bit answer contained in the accumulator 202 of Fig. 23 represents at least a very close approximation of the value of the electrical current in the line being measured. It is this value that is utilized by the microprocessor U2 in a manner described previously and hereinafter for controlling the contactor 10. At HCYCLE 33 the entire process is re-initialized for subsequent utilization on another transformer or transducer 62B and thereafter 62C. Of course, this is repeated periodically in a regular manner by the microprocessor U2.

Plot 220B of Fig. 25C shows that the voltage $V_{C101}$ increases as a function of the integration of the current iCH of Fig. 25A. For each positive half cycle of the charging current iCH, no integration occurs. However, for each negative half cycle an integration following the negative cosine curve occurs. These latter values are accumulated to form voltage $V_{C101}$. Voltage $V_{C101}$ thus increases in correspondence with the value of the line current being sampled over the time represented by the thirty-two half cycles until the capacitive element C101 is discharged to zero during the thirty-third half cycle.

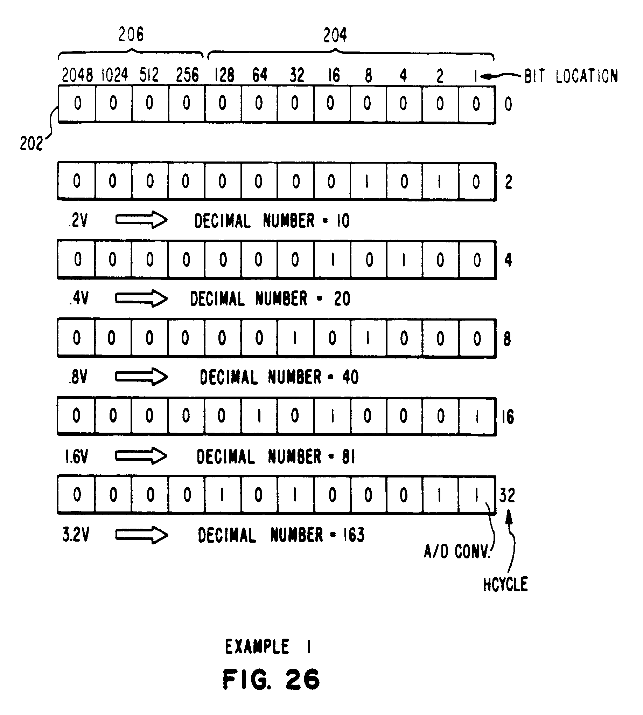

Referring now to Figs. 22, 24, 25 and 26 the accumulator portrait for Example 1, is shown and described. In Example 1 the 1/2 per unit charging current iCH 230a is utilized to charge the capacitor C101 to produce the capacitor voltage VC101. The profile for this voltage is shown generally at 230b on Fig. 25C. This voltage is sampled by the "RANGE" algorithm according to function block 184 of Fig. 22. At the "2", "4", "8", "16" and "32" HCYCLE benchmarks the "RANGE" algorithm then determines as is set forth in function block 186 of Fig. 22 whether the previous analog-to-digital conversion result was equal to or greater than 80 hex. 80 hex equals a digital number of 128. If the answer to that question is no then the analog voltage VC101 present on the input AN1 of the analog-to-digital converter 200 is digitized and saved as is indicated in function block 192 of Fig. 22 and shown graphically in Fig. 26. HCYCLE is incremented by 1 and the routine is begun again. As long as the previous analog-to-digital conversion result is not greater than or equal to 80 hex there is no need to utilize the "left shifting" technique of the present invention. Consequently, Example 1 depicted in Fig. 26 shows a sampling routine which never is forced to utilize the left shifting technique. In particular in Example 1 of Fig. 26 at HCYCLE equal to .2 volts is available at the input of the analog-to-digital converter 200 on terminal AN1 this will be digitized providing a binary number equivalent to the decimal number 10. The binary number in question has a digital 1 in the "2" and "8" locations of the memory portion 204 and digital zeros in all the other bit locations. The "HCYCLE 4" digitizes the analog voltage .4 volts provides a decimal number of 20 which places a digital 1 in the "16" "4" bit locations of the portion 204 with digital zeros in all other portions. At "HCYCLE 8" .8 volts is digitized providing a binary number which is equivalent to the decimal number 40 and which is formed by placing digital ones in the "32" and "8" locations of the portion 204. At HCYCLE 16 1.6 volts is digitized providing a digital number which is represented by the decimal number 81. The digital number has digital ones in the "64" and "16" bit locations of the portion 204. Finally, at HCYCLE equal 32 3.2 volts is digitized generating a digital number equivalent to the decimal number 163. Where the digital number in question has digital 1 in the "128", "32", "2" and "1" bit locations of the accumulator 204. At this point the "RANGE" algorithm has been complete for Example 1. It will be noted as was described previously that the "RANGE" algorithm never entered into function block 188 others a left shifting would be required. However, as will be described hereinafter with respect to Example 2 and Example 3, the left shifting technique will be utilized.

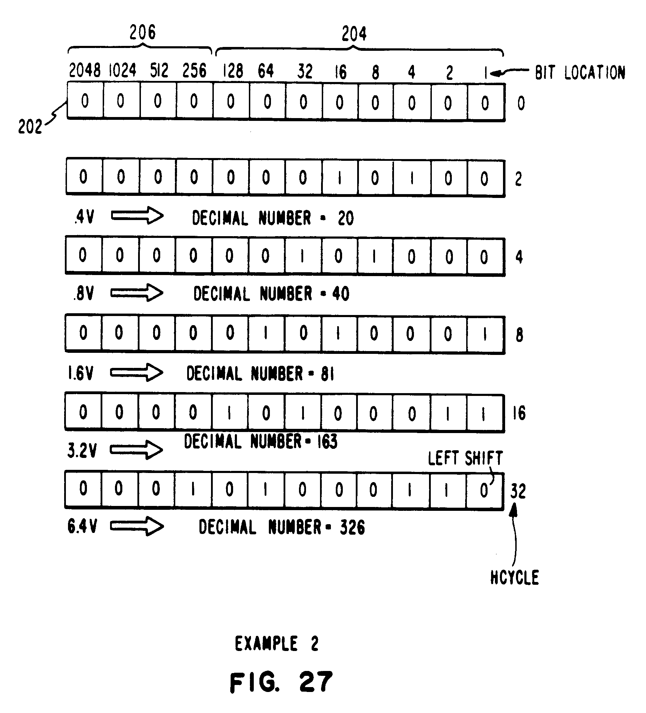

Referring now to Figs. 22, 24, 25 and 27 an Examples 2 is depicted in which a one per unit charging current iCH 220a is utilized to generate a voltage VC101 across the capacitive element C101. The voltage generated when plotted against HCYCLE is shown at 220b in Fig. 25C. Once again the "RANGE″" algorithm of Fig. 22 is utilized. As was the case previously the "RANGE″" algorithm is utilized in such a manner that the memory locations 202 are updated at the "2", "4", "8", "16" and "32" HCYCLE samples. At the "2" HCYCLE sample .4 volts is digitized providing a digital number in the portion 204 of the accumulator 202 which is equivalent to the decimal number 20. That digital number has a digital 1 in the "16" and "4" bit locations of the portion 204. There are digital zeros in all the other bit locations. At HCYCLE equal 4 .8 volts is digitized providing a digital number equivalent to the decimal number 40. The digital number has a digital 1 in the "32" and "8" bit locations of the portion 204 of the accumulator 202. At HCYCLE equal 8 1.6 volts is digitized providing a digital number in the portion 204 of the accumulator 202 which is equivalent to the decimal number 81. The digital in question has digital or logic ones in bit locations "64", "16" and "1". At HCYCLE equal 16 3.2 volts is digitized providing a digital number for portion 204 of accumulator 202 which is equivalent to the decimal number 163. The latter digital number has digital ones in bit locations "128", "132", "2" and "1". At HCYCLE equal 32 the "RANGE" algorithm determines by utilizing functional block 186 that the previous A-to-D result produced a digital number which was larger than 80 hex. Consequently, for the first time in this series of examples, functional block 188 is utilized and a "left shift" is accomplished. Consequently, even though 6.4 volts is available at the input of the analog-to-digital converter 200 for digitization, the digitization does not take place for the simple reason that the output of the analog-to-digital converter would be unreliable with such a large analog number on its input. Instead, the digital number stored in the portion 204 of the accumulator 200 during the previous digitization of the 3.2 volt analog signal is merely shifted one place to the left for each bit in the digital number to provide a new digital number which is equivalent to the decimal number 326. The new digital number utilizes a portion of the spill-over member 206 of the accumulator 202 as is clearly shown in Fig. 27. The new digital number has digital ones in the "256", "64", "4" and "2" bit locations of the expanded accumulator 202. Notice how the digital number in the "32" HCYCLE location of Fig. 27 is the same digital number shown in HCYCLE location "16" but moved one bit location to the left. This example shows the left shifting technique in operation. The number stored in the accumulator 202 at the end of the 32nd HCYCLE is indicative of the line current $i_{L1}(t)$ that was measured in the overload relay portion 60′ of the contactor 10.

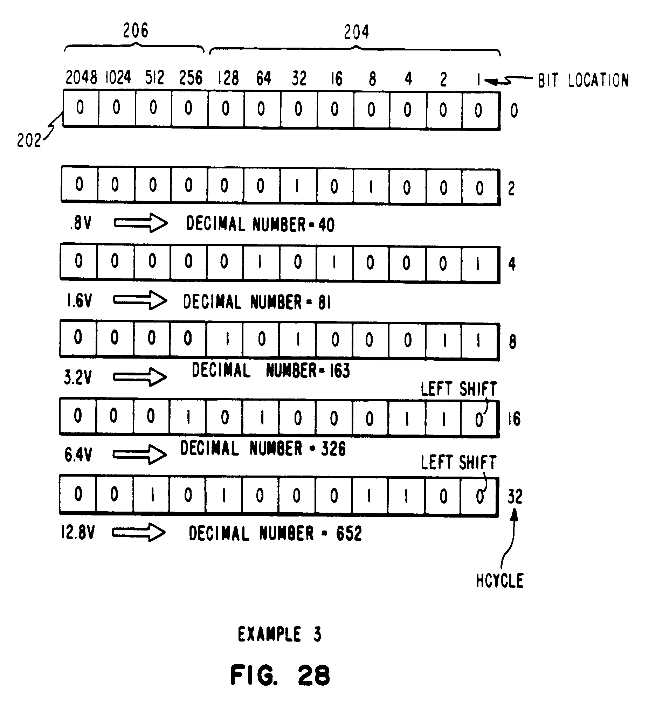

Referring now to Figs. 22, 24, 25 and 28 still a third example of the left shifting technique is described. In particular in Example 3 a two per unit charging current iCH indicated at 240a in Fig. 25B is integrated by the capacitor C101 to provide the voltage VC101. This voltage produces an output profile similar to that shown with respect to Examples 1 and 2 in Fig. 25C but following the slope generally depicted at Example 3 in Fig. 25C. The step-like relationship for the voltages is deleted from Example 3 in order to avoid confusion. However it is to be understood that the step-like voltages exist for Example 3 in much the same way as they exist for Example 1 and Example 2. With regard to Example 3 the "RANGE" algorithm samples at HCYCLE equal "2", "4" and "8" and provides appropriate analog-to-digital conversions to update the portion 204 of the accumulator 202. However, at HCYCLE samples "16" and "32" the portion 204 of the accumulator 202 is updated by two successive serial left shifts of the previous information stored in the location 204 rather than by an analog-to-digital conversion. It is clear that an analog-to-digital conversion would have produced an unreliable result for the latter two samples. To be specific at HCYCLE equal "2" .8 volts is digitized producing a digital number equivalent to the decimal number 40. The digital number has digital ones in the "32" and "8" bit locations of the portion 204 of the accumulator 202. At the "4" HCYCLE sample 1.6 volts is digitized producing a digital number equivalent to the decimal number 81. The latter digital number has digital ones in the "64", "16" and "1" bit locations of the portion 204 of the accumulator 202. At sample HCYCLE equals 8 3.2 volts is digitized providing a digital number equivalent to the decimal number 163. The digital number has digital ones in the "128", "32", "2" and "1" bit locations of the portion 204 of the accumulator 200. At HCYCLE equal 16 the "RANGE" algorithm recognizes that the previous A-to-D result (equivalent to the digital number 163) was greater than 80 hex and therefore the accumulator 202 is updated not by a way of an analog-to-digital conversion of voltage on the input of the analog-to-digital converter 200 but rather than by left shifting by one bit the digital information previously stored in the accumulator 202 as a result of completion of the HCYCLE equal "8" sample. Consequently, for the "16" HCYCLE sample a digital number equivalent to the decimal 326 is formed. This is done by left shifting the information that was previously stored in the accumulator by one bit to the left. This causes the aforementioned digital number to pour over into one bit location of the pour-over portion 206 of the accumulator 202. The new digital number has a digital 1 in the "256", "64", "4" and "2" bit locations of the accumulator 202. At the HCYCLE equal "3" sample the number stored previously in accumulator 202 is left shifted once again in the accumulator 202 to now occupy two of the locations in pour-over portion 206 as well as all eight locations in portion 204. The new digital number has a decimal equivalent of 652. The new digital number has a digital one in the "512" location, "128" location, the "8" bit location and the "4" bit location. This number is then utilized to represent the current measured in the line by way of the overload relay board 60, the value stored in the accumulator 202 will be utilized as described previously for performing useful functions by the contactor or controller 10.

Referring once again to Figs. 7A through 7D apparatus and technique associated with switch SW101 and the 8-bit static shift register U104 is described. The inputs designated H0 through H4 on switch SW101 represents switch arrangements for programming a digital number which can be read by the microprocessor U2 for making a decision and determination about the ultimate value of the full load current detected by the previously described system. These switch values as well as the switch values associated with "AM", "C0", and "C1" are serially read out by the microprocessor U2 as part of the signal on line SW in correspondence with input information provided by the A, B and C input signals. Input information SW is provided to input terminal I10 of the microprocessor U2. By utilizing the heater switch arrangement, 16 values of ultimate trip can be selected with four heater switches, H0 through H3, programmed in a binary fashion. The switches replace mechanical heaters which form part of the prior art for adjusting the overload range of the motor. There are also provided two inputs C0 and C1 which are utilized to input the motor class. A class 10 motor will tolerate a locked rotor condition for 10 seconds and not be damaged, a class 20 motor, for 20 seconds, and a class 30 motor for 30 seconds. Locked rotor current is assumed to be six times normal current.

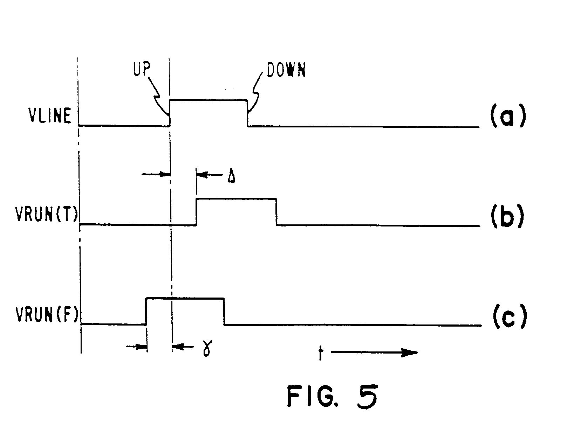

Referring once again to Figures 7A and 7B, Figure 11 and Figure 5, apparatus and method for discriminating between a true input signal and a false input signal on the "RUN", "START", and "RESET" inputs is depicted. In Figure 11, a parasitic distributed capacitance CLL is shown between inputs lines connected to the "E" and "P" terminals of the terminal block J1 of the board 28. This capacitance ray be due to the presence of extremely long input lines between the pushbuttons "STOP", "START" and "RESET" and the terminal block J1. Similar capacitance may exist between the other lines shown illustratively in Figure 11. Parasitic capacitance has the undesirable feature of coupling signals among the input lines. The affect of this is to introduce a false signal which appears to the microprocessor U2 to be a true signal indicative of the fact that the pushbutton "STOP", "START" and "RESET" are closed when in fact they may be open. Therefore, the purpose of the following apparatus is to distinguish between a true signal and a false signal on the latter mentioned input lines. It is necessary to understand that the capacitive current iCLL flowing through the distributed parasitic capacitance CLL leads the voltage which appears across it, that is, the voltage between terminals "E" and "P". Referring to Figure 5 A, VLINE as seen by the microprocessor U2 in its truncated form is shown. Figure 5C shows the voltage that the microprocessor U2 sees, for example, on terminal B41 thereof as the result of the phantom current iCLL flowing through resistive element R3, the capacitive element C4 and the internal impedance on the RUN input terminal of the circuit U1. This voltage identified as VRUN(F) -- for a false indication of voltage -- leads the voltage VLINE by a value $\gamma$. If the capacitive elements CX and C4 are different and more specifically if the capacitive element CX is larger than the capacitive element C4, a true VRUN signal VRUN(T), that is a signal produced by closing the STOP switch as shown in Figure 11, will be nearly in phase with voltage VLINE. The only difference being due to the difference in capacitance of the capacitive elements CX and C4. If capacitive element CX is smaller than capacitive element C4, the difference will cause the true voltage VRUN(T) to lag VLINE by an amount $\Delta$ as shown in Figure 5B. The microprocessor U2 therefore is asked to compare voltage VLINE with the voltage on input terminal B41 within a short period of time - - equal to or smaller than $\Delta$ -- after voltage VLINE has changed state or passed through an alternation indicated at "UP" and "DOWN" in Figure 5A. If the digital value of the voltage on terminal B41 is the opposite digital signal from that associate with the voltage VLINE at this time then the signal is a true signal as shown in Figure 5B. If on the other hand it is of the same polarity, it is a false signal as shown in Figure 5C. That is to say, for example, if voltage VLINE is measured within time period $\Delta$ after an "UP" and compared with the voltage on terminal B41, and the voltage on terminal B41 is a digital zero, the voltage signal on terminal B41 is a true signal. However, if the voltage signal is a digital I it is indicative that the voltage signal on terminal B41 is a false signal. By choosing the appropriate values for capacitive element CX and capacitive element C4, the amount by which a true signal will lead the line voltage, i.e., the delay $\Delta$ can be varied. The value of $\Delta$ is less than the value $\gamma$ so that the sign of a false signal cannot also be different from the sign of the reference voltage during the sampling or comparison interval.

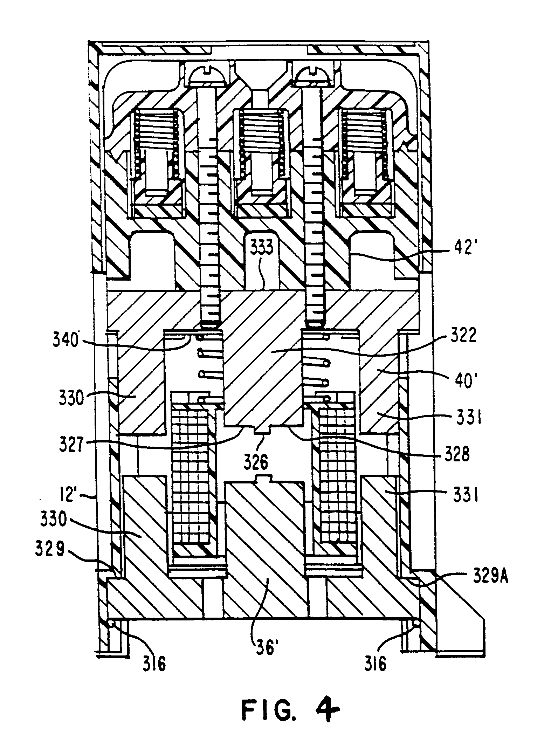

Referring now to Figure 6, a printed circuit card shown to that in Figs. 8, 9 and 10 is depicted for another embodiment of the invention. In the embodiment of Figure 6 elements which are similar to elements of the apparatus shown in Figs. 8, 9 and 10 are depicted with the same reference symbols primed ('). For simplicity of illustration and description reference may be had to Figs. 8, 9 and 10 for identifying the similar elements and their interrelationship. It will be noted with respect to the apparatus of Figures 8, 9 and 10 that a ribbon connector 64 is utilized to interconnect solder connectors J2 with J101 and J102. However, in the embodiment of the invention shown in Figure 6 the ribbon connector 64 is eliminated. Rather there is provided an electrically insulated base 300 in which are disposed male plug connectors 303. These are shown on the overload relay board 60'. On printed circuit board 28' is provided the female connector 302 for the male connector 300 of circuit board 60'. Female connector 302 has recesses or openings 304 therein which match or are complementary with the male plugs 303 of connector 300. Bobbin 32' is interconnected with board 28' by way of pens 318 which are soldered into appropriate openings in board 28' for assisting in supporting the board 28' as will be described hereinafter with respect to Figs. 3 and 4. As was the case with respect to the embodiment shown in Figs. 8, 9 and 10 the entire circuit board is broken after assembly at 100' and installed so that the connector 300 mates with the connector 302 in a manner shown and described with respect to Figures 3 and 4. In addition, a separate terminal block JX is provided for interconnection with a separate internal communication network (IUCOM) for communication between separate contactors and remote control and communication elements.

Referring now to Figs. 3 and 4 an embodiment of the invention similar to that shown in Figs. 1 and 2 is depicted. In this embodiment of the invention elements which are identical to or similar to corresponding elements in the apparatus of Figs. 1 and 2 are depicted with the same reference characters primed ('). For purposes of simplicity and clarity of illustration and description reference may be had to the description associated with the apparatus of Figs. 1 and 2 for the understanding of the cooperation, function and operating of similar or identical elements in Figs. 3 and 4. The circuit boards 60' and 28' are shown in their final assembled condition with the plug 300 interconnected with the female receptacle 302 in a manner described previously. In such an arrangement male electrically conducting members 303 are inserted into and make electrical contact with similar female members 304 for interconnecting elements on circuit board 60' with elements on circuit board 28'. It is also to be understood that circuit board 60' depicted in Figs. 3 and 4, for example, is interconnected with circuit board 28' in a manner which leaves an offset portion upon which the extra terminal block JX is disposed. The embodiment of the invention depicted in Figs. 3 and 4 shows a contactor comprising a one-piece thermoplastic insulating base 12' that holds terminal straps 20' and 24', terminal lugs 14' and 16', respectively, and stationary contacts 22' and 26', respectively. Appropriate screws 400 hold the stationary contacts and the terminal straps to the base. The base 12' also provides a positioning and a guidance system for moving contacts 46', 48', cross bar 44', spacer or carrier 42' and the armature 40' which will be described in greater detail hereinafter. The overload relay board 60' and the coil control board 28' are supported within the base 12' in a unique manner. More specifically, (as is best seen in Fig. 4) permanent magnet or slug 36' which may be identical to armature 40' or very similar thereto has a lip thereon 329 which is forcefully held against a corresponding lip 330 in the base 12' by the action of a retaining spring or retainer 316. This firmly marries the slug or permanent magnet 36' to the base 12'. In turn, the slug or permanent magnet 36' has a second lip 314 thereupon (best shown in Fig. 3 ) which engages and is forcefully held against a corresponding lip 315 in the bobbin 317 of the coil assembly 30'. The retaining pins 318 are disposed in the bobbin 317 and in turn are soldered to or otherwise securely disposed upon the coil control board 28' so that the coil control board 28' which may comprise flexible, electrically insulating material is securely supported in the central region thereof. The corners of the circuit control board 28' are supported directly upon the base 12' at 320, for example. The overload relay board 60' is supported perpendicularly upon the coil control board 28' by the interaction of the pins and connectors 300, 302, 303 and 304. Coil assembly 30' is supported at the other end thereof by kickout spring 34' so that bobbin 317 is securely held in place between the aforementioned ridge or lip 314 on the magnet 36' and the base 12' by way of the compressive force of the spring 34'. As is best seen by reference to Fig. 4, the top portion of the spring 34' is trapped against a lip 340 on the bottom portion of the carrier or spacer 42' and moves therewith during the movement of the movable system which includes the moving contacts 46' and 48', the spacer 42' and the armature 40'.

Further explanation regarding the operation of transducer 62S of Figure 18 is set forth. This description is especially useful for understanding how the transducer 62S may be utilized in electrical apparatus such as and electrical contactor, an electrical meter or an electrical relaying system for example to provide a voltage output V across the secondary winding thereof which is proportional to the derivative with respect to time of the current i in the primary winding thereof. This may be utilized for measurement or detection of current in a large range of current i where the error in the output voltage v relative to the current i in the large range is extremely small. For example, for a current range which varies between .1 amps and 2000 amps the output voltage v is a relatively faithful representation of the magnitude of the derivative of the

EP 0 279 596 B1

current i with an error which is no greater than 1%. If iron powder is used for the core 120, (see Figure 11-11 in the publication entitled, "Ferromagnetism" by R. M. Bozorth, as shown on page 489) the permeability $\mu$ as a function of the field strength H is relatively constant at a value $\mu_0$ over a relatively wide range of field strengths known in a region known as the Rayleigh region or range. The Rayleigh constant $\lambda$ which is equal to the slope ($\lambda$) of the magnetization curve is approximately equal to zero over the Rayleigh range for iron powder.

Equation (9) shows the relationship of permeability $\mu$ as a function of the initial permeability $\mu_0$, the Rayleigh constant $\lambda$ and the field strength H in the Rayleigh range for any material.

$$\mu = \mu_0 + \lambda H \qquad (9)$$

$$H = \frac{iN1}{l} \qquad (10)$$

Equation (10) shows the relationship of field strength H versus current i.

$$\frac{\phi}{A} = \beta = \mu H = \frac{\mu N1 i}{l} \qquad (11)$$

Equation (11) shows the relationship of flux ($\phi$), the flux density ($\beta$) and field strength (H).

$$v = N2 \frac{d\phi}{dt} \qquad (12)$$

Equation (12) shows the relationship of the output voltage on the secondary winding of the current-to-voltage transducer 62S as a function of flux and the number of turns N2 in the secondary winding.

$$v = \frac{N1N2A}{l} \frac{d\mu i}{dt} \qquad (13)$$

Equation (13) shows equation (12) with the constant values clustered.

$$v = \frac{N1N2A}{l} \frac{d(\mu_0 + \lambda H)i}{dt} \qquad (14)$$

Equation (14) shows equation (13) with equation (9) substituted.

$$v = \frac{N1N2A}{l} \mu_0 \frac{di}{dt}: \text{ if } \lambda = 0 \qquad (15)$$

Equation (15) shows equation (14) for the special case when $\mu_0$ is constant.

$$v = \frac{kdi}{dt}: \text{ if } \lambda = 0 \qquad (16)$$

17

Equation (16) depicts equation (15) in a more simplified case well within the excitation or nonsaturation region for a core such as 120.

## IDENTIFICATION OF REFERENCE NUMERALS USED IN THE DRAWINGS

| LEGEND | REF. NO. | FIGURE |
|---|---|---|
| INTEGRATOR | 113 | 13 |
| IS THIS A POSITIVE 1/2 CYCLE | 152 | 19 |
| CHECK STATUS OF "START", "RUN" AND "RESET" INPUTS AND SET FLAGS ACCORDING TO THE STATUS | 154 | 19 |
| DISCHARGE CAPACITORS | 156 | 19 |
| RELEASE CAPACITORS | 158 | 19 |
| IS THIS A POSITIVE 1/2 CYCLE | 162 | 20 |
| SELECT AN3 INPUT TO A/D | 164 | 20 |
| PERFORM A/D CONVERSION | 166 | 20 |
| STORE RESULT FOR LATER ANALYSIS | 168 | 20 |
| FETCH CONDUCTION DELAY, WAIT. | 172 | 21 |
| TURN ON TRIAC | 174 | 21 |
| DO REPETATIVE A/D CONVERSIONS ON COIL CURRENT. FIND MAX. | 176 | 21 |
| IS MAX. CURRENT $\geq$ REGULATION POINT | 178 | 21 |
| INCREMENT CONDUCTION DELAY | 180 | 21 |
| DECREMENT CONDUCTION DELAY | 182 | 21 |
| IS HCYCLE= 2,4,8,16,32, | 184 | 22 |
| IS PREVIOUS A/D RESULT=>80H | 186 | 22 |
| SHIFT PREVIOUS RESULT LEFT 1 BIT | 188 | 22 |
| INCREMENT HCYCLE | 190 | 22 |
| DO NEW A/D CONVERSIONS AND SAVE | 192 | 22 |
| OUTPUT A HIGH SIGNAL ON TRIG | 212 | 24 |
| DELAY 20 $\mu$ sec | 214 | 24 |
| OUTPUT A LOW SIGNAL ON TRIG | 216 | 24 |

## Claims

1. A contactor of the kind which opens and closes an electrical circuit, comprising:

a current-to-voltage transducer and voltage sensitive means disposed to receive an electrical voltage V and to open said electrical circuit when required in response thereto, said current-to-voltage transducer comprising:

a homogeneous magnetic core (120);

a primary winding (L1) disposed to electromagnetically interact with said homogeneous magnetic core (120) for providing magnetic flux in said homogeneous magnetic core (120) in proportion to the amount of electrical current I flowing in said primary winding means (L1) for values of said electrical current I within a given range of current I;

said homogeneous magnetic core (120) comprising generally homogeneously dispersed magnetic

18

regions (122) and non-magnetic regions (124) therein, said homogeneous magnetic core (120) having a Rayleigh Constant $\lambda$ of such magnitude that a value $\lambda H$ is significantly less than the initial permeability $\mu_0$ of the homogeneous magnetic core (120), thus causing the relationship:

$$\frac{d(\mu_0 + \lambda H)I}{dt} = \mu_0 \frac{dI}{dt}$$

for said entire range of current I, where H equals the electromagnetic field strength attributable to said magnetic flux;

a secondary winding (112) disposed on said homogeneous magnetic core (120) for providing said electrical voltage V at the output terminals thereof which is approximately proportional to the first derivative of said current I with respect to time for said entire range of current I.

2. A contactor as claimed in claim 1, wherein said magnetic regions and said non-magnetic regions are microscopic.

3. A contactor as claimed in claim 1 or 2, wherein said magnetic core (120) comprises powdered metal particles separated by regions of low magnetic permeability.

4. A contactor as claimed in claim 3, wherein said powdered metal comprises ferrite.

5. A contactor as claimed in claim 3 or 4, wherein said powdered metal is sintered.

6. A contactor as claimed in any of claims 3 to 5, wherein said regions of low magnetic permeability comprise air gaps.

7. A contactor as claimed in any preceding claim, wherein said magnetic core is toroidal.

8. A contactor as claimed in any preceding claim, wherein said total magnetic permeability is generally constant for values of said electrical current I less than or equal to a predetermined amount.

9. A contactor as claimed in any preceding claim, wherein said voltage V is directly proportional to said current I when I is sinusoidal.

10. A contactor as claimed in any preceding claim, wherein the relationship of $\lambda H$ to $\mu_0$ is such that the contribution to the change in voltage V related to the value:

$$\frac{d(\mu_0 + \lambda H)I}{dt}$$

varies over said range of current I by $\leq 1\%$ caused by the contribution to the change in voltage V related to the value:

$$\frac{d\lambda H I}{dt}$$

11. A contactor as claimed in any preceding claim wherein said primary winding means comprises a single turn.

**Patentansprüche**

1. Schütz, welches eine elektrische Schaltung öffnet und schließt, mit
   einem Strom-Spannungs-Wandler und einer auf eine Spannung reagierenden Einrichtung, die eine
   elektrische Spannung V empfängt und in Reaktion darauf, falls erforderlich, die elektrische Schaltung
   öffnet, wobei der Strom-Spannungs-Wandler aufweist:
   einen homogenen Magnetkern (120);
   eine Primärwicklung (L1), die so angeordnet ist, daß sie mit dem homogenen Magnetkern (120)
   wechselwirkt, um in dem homogenen Magnetkern (120) einen magnetischen Fluß proportional zum
   Betrag des elektrischen Stroms I zu erzeugen, der in der Primärwicklungseinrichtung (L1) fließt, für
   Werte des elektrischen Stroms I innerhalb eines gegebenen Bereichs des Stroms I;
   wobei in dem homogenen Magnetkern (120) allgemein homogen verteilte magnetische Bereiche (122)
   und nicht-magnetische Bereiche (124) vorgesehen sind, und der homogene Magnetkern (120) eine
   Rayleigh-Konstante $\lambda$ solcher Größe aufweist, daß ein Wert $\lambda H$ deutlich niedriger ist als die ursprüngliche Permeabilität $\mu_0$ des homogenen Magnetkerns (120), so daß folgende Beziehung hervorgerufen
   wird:

$$\frac{d\,(\mu_0 + \lambda H)\,I}{dt} = \mu_0\,\frac{dI}{dt}$$

   für den gesamten Bereich des Stroms I, wobei H gleich der dem magnetischen Fluß zuschreibbaren
   Stärke des elektromagnetischen Feldes ist;
   eine Sekundärwicklung (112), die auf dem homogenen Magnetkern (120) angeordnet ist, um an ihren
   Ausgangsklemmen die elektrische Spannung V bereitzustellen, die annähernd proportional zur ersten
   zeitlichen Ableitung des Stroms I für den gesamten Bereich des Stroms I ist.

2. Schütz nach Anspruch 1, bei welchem die magnetischen Bereiche und die nicht-magnetischen
   Bereiche mikroskopisch sind.

3. Schütz nach Anspruch 1 oder 2, bei welchem der Magnetkern (120) pulverförmige Metallteilchen
   aufweist, die durch Bereiche niedriger magnetischer Permeabilität getrennt sind.

4. Schütz nach Anspruch 3, bei welchem das pulverförmige Metall Ferrit aufweist.

5. Schütz nach Anspruch 3 oder 4, bei welchem das pulverförmige Metall gesintert ist.

6. Schütz nach einem der Ansprüche 3 bis 5, bei welchen die Bereiche niedriger magnetischer Permeabilität Luftspalte umfassen.

7. Schütz nach einem der voranstehenden Ansprüche, bei welchem der Magnetkern toroidförmig ist.

8. Schütz nach einem der voranstehenden Ansprüche, bei welchem die gesamte magnetische Permeabilität für Werte des elektrischen Stroms I kleiner oder gleich einem vorbestimmten Betrag im wesentlichen konstant ist.

9. Schütz nach einem der voranstehenden Ansprüche, bei welchem die Spannung V direkt proportional
   zum Strom I ist, wenn I sinusförmig ist.

10. Schütz nach einem der voranstehenden Ansprüche, bei welchem die Beziehung von $\lambda H$ zu $\mu_0$ derart
    ist, daß der Beitrag zur Änderung der Spannung V in Bezug auf den Wert:

$$\frac{d\,(\mu_0 + \lambda H)\,I}{dt}$$

über den Bereich des Stroms I um ≤ 1% variiert, hervorgerufen durch den Beitrag zur Änderung der Spannung V in Bezug auf den Wert:

$$\frac{d\lambda HI}{dt}$$

**11.** Schütz nach einem der voranstehenden Ansprüche, bei welchem die Primärwicklungseinrichtung eine einzige Windung aufweist.

## Revendications

**1.** Contacteur du type qui ouvre et ferme un circuit électrique, comprenant :
- un transducteur courant/tension et un moyen sensible à la tension, disposés de manière à recevoir une tension électrique V et à ouvrir ledit circuit électrique si besoin est en réponse à cette tension, ledit transducteur courant/tension comprenant :
  . un noyau magnétique homogène (120) ;
  . un enroulement primaire (L1) disposé de manière à agir réciproquement de façon électromagnétique avec ledit noyau magnétique homogène (120) pour créer un flux magnétique dans ledit noyau magnétique homogène (120) en proportion de la quantité de courant électrique I circulant dans ledit enroulement primaire (L1) pour les valeurs du courant électrique (I) se situant dans une plage donnée de courant I ;
  ledit noyau magnétique homogène (120) comprenant des régions magnétiques (122) et des régions non magnétiques (124) dispersées de façon globalement homogène, ledit noyau magnétique homogène (120) présentant une constante de Rayleigh λ d'une grandeur telle que la valeur λH est notablement inférieure à la perméabilité initiale $\mu_0$ du noyau magnétique homogène (120), en créant ainsi la relation :

$$\frac{d(\mu + \lambda H)I}{dt} = \mu_0 \frac{dI}{dt}$$

  pour la plage complète de courant I, où H est égal à la densité de champ électromagnétique pouvant être attribuée audit flux magnétique ;
  . un enroulement secondaire (112) disposé sur ledit noyau magnétique homogène (120) pour fournir à ses bornes de sortie ladite tension électrique V qui est à peu près proportionnelle à la dérivée première du courant I par rapport au temps pour la plage complète de courant I.

**2.** Contacteur selon la revendication 1, dans lequel lesdites régions magnétiques et lesdites régions non magnétiques sont microscopiques.

**3.** Contacteur selon la revendication 1 ou 2, dans lequel le noyau magnétique (120) comprend des particules de métal en poudre séparées par des régions de faible perméabilité magnétique.

**4.** Contacteur selon la revendication 3, dans lequel ledit métal en poudre comprend une ferrite.

**5.** Contacteur selon la revendication 3 ou 4, dans lequel le métal en poudre est fritté.

**6.** Contacteur selon l'une quelconque des revendications 3 à 5, dans lequel les régions de faible perméabilité magnétique constituent des entrefers.

**7.** Contacteur selon l'une quelconque des revendications précédentes, dans lequel ledit noyau magnétique est torique.

**8.** Contacteur selon l'une quelconque des revendications précédentes, dans lequel la perméabilité magnétique totale est constante d'une façon générale pour des valeurs du courant électrique I inférieures ou égales à une valeur prédéterminée.

**9.** Contacteur selon l'une quelconque des revendications précédentes, dans lequel la tension V est directement proportionnelle au courant I lorsque I est sinusoïdal.

**10.** Contacteur selon l'une quelconque des revendications précédentes, dans lequel la relation entre $\lambda H$ et $\mu_0$ est telle que la contribution à la variation de la tension V liée à la valeur :

$$\frac{d(\mu_0 + \lambda H)I}{dt}$$

varie dans ladite plage de courant I de $\leq 1\%$ dû à la contribution à la variation de la tension V liée à la valeur :

$$\frac{d\lambda HI}{dt}$$

**11.** Contacteur selon l'une quelconque des revendications précédentes, dans lequel l'enroulement primaire comprend une seule spire.

22

FIG. 1

FIG. 2

FIG. 3

333

42'

340

322

40'

330

331

327

328

326

12'

330

331

329

329A

316

36'

316

FIG. 4

FIG. 5

FIG. 6

FIG. 7A

FIG. 7B

120 VAC

R16

CR4

R17     C13

RES

R8

RESET     B43     GND
START     B42
RUN       B41
LINE      B40

CL2
CL1
DVL     +5V
RES

R14
DEADMAN     O22     O33     $\overline{Z}$
O32     A
C8     O31     B
O30     C

$\overline{VDDOK}$     INTO     I10     SW

R15
TRIG     B52

C9
AGND
LVOLT     AN3
COILCUR     AN2
MCUR     AN1
DELAY     AN0
+5V     REF
VDD     VDD

C16

28     U2

FIG. 7C

CR102

R104

CR104

U105

R103

+10V

+5V,VZ

−7V

MCUR

OVERLD

J102

U103

P101

CR105

CR106

LED1

C103

−7V

Z
A
B
C
SW
DELAY

J101

+5V

P102

1  AUTO/MANUAL/RESET (AM)
2  C1
3  C0  (SEE TABLE)
4  SPARE H4 (SP)
5  H3 (MSB)
6  H2
7  H1    HEATER VALUE
8  H0 (LSB)

SW101

64

60

| C1 | C0 |                     |
|----|----|---------------------|
| 0  | 0  | STARTER CLASS 10    |
| 0  | 1  | STARTER CLASS 20    |
| 1  | 0  | STARTER CLASS 30    |
| 1  | 1  | OVERLOAD DISABLE    |

FIG.  7D

32

FIG. 8

J1

32

J2

J3

64

J1101

J102

100

102

62A

62B

62C

P101

SW101

P102

J1

28

32

31A

J2

64

J102

60

62

**FIG. 9**

FIG. 10

FIG. 11

EP 0 279 596 B1

FIG. 12

FIG. 13

FIG. 14

FIG. 15

FIG. 16

FIG. 17

FIG. 18

READSWITCHES

IS THIS A POSITIVE 1/2 CYCLE — 152

N → RELEASE CAPACITORS — 158 → RETURN

Y

CHECK STATUS OF "START","RUN" AND "RESET" INPUTS AND SET FLAGS ACCORDING TO THE STATUS — 154

DISCHARGE CAPACITORS — 156

RETURN

**FIG. 19**

READ VOLTS

IS THIS A POSITIVE 1/2 CYCLE — 162

N → RETURN

Y

SELECT AN3 INPUT TO A/D — 164

PERFORM A/D CONVERSION — 166

STORE RESULT FOR LATER ANALYSIS — 168

RETURN

**FIG. 20**

FIG. 21

FIG. 22

FIG. 23

FIG. 24

FIG. 25C

FIG. 25B

FIG. 25A

EXAMPLE I

FIG. 26

206                204

| 2048 | 1024 | 512 | 256 | 128 | 64 | 32 | 16 | 8 | 4 | 2 | 1 | ← BIT LOCATION |

| 0 | 0 | 0 | 0 | 0 | 0 | 0 | 0 | 0 | 0 | 0 | 0 | 0 |

202

| 0 | 0 | 0 | 0 | 0 | 0 | 0 | 1 | 0 | 1 | 0 | 0 | 2 |

.4V ⟹ DECIMAL NUMBER = 20

| 0 | 0 | 0 | 0 | 0 | 0 | 1 | 0 | 1 | 0 | 0 | 0 | 4 |

.8V ⟹ DECIMAL NUMBER = 40

| 0 | 0 | 0 | 0 | 0 | 1 | 0 | 1 | 0 | 0 | 0 | 1 | 8 |

1.6V ⟹ DECIMAL NUMBER = 81

| 0 | 0 | 0 | 0 | 1 | 0 | 1 | 0 | 0 | 0 | 1 | 1 | 16 |

3.2V ⟹ DECIMAL NUMBER = 163

LEFT SHIFT

| 0 | 0 | 0 | 1 | 0 | 1 | 0 | 0 | 0 | 1 | 1 | 0 | 32 |

6.4V ⟹ DECIMAL NUMBER = 326

HCYCLE

EXAMPLE 2

# FIG. 27

EXAMPLE 3

FIG. 28